# EUROPEAN PATENT SPECIFICATION

(11) **EP 4 343 849 B1**
(45) Date of publication and mention of the grant of the patent: **10.12.2025**
(21) Application number: 23196798.5
(22) Date of filing: 12.09.2023
(51) Int. Cl.: H01L 21/285, H01L 21/768, H01L 23/485, H01L 23/528, H10D 30/01, H10D 30/43, H10D 30/67, H10D 62/10, H10D 84/01, H10D 84/03, H10D 84/85, H10D 64/01, B82Y 10/00

(54) **INTEGRATED CIRCUIT DEVICE**
INTEGRIERTE SCHALTUNGSANORDNUNG
DISPOSITIF DE CIRCUIT INTÉGRÉ

(30) Priority: 21.09.2022 KR 20220119547
(43) Date of publication of application: 27.03.2024
(73) Proprietor: Samsung Electronics Co., Ltd., Suwon-si, Gyeonggi-do 16677 (KR)
(72) Inventor: SONG, Seunghyun, 16677 Suwon-si (KR); KIM, Minsuk, 16677 Suwon-si (KR); KIM, Pilkwang, 16677 Suwon-si (KR); OKAGAKI, Takeshi, 16677 Suwon-si (KR); KIM, Geunmyeong, 16677 Suwon-si (KR); KIM, Ahyoung, 16677 Suwon-si (KR); KIM, Yoonsuk, 16677 Suwon-si (KR)
(74) Representative: Marks & Clerk LLP

(56) References cited:
- EP-A1- 3 940 761
- WO-A1-2018/039645
- CN-A- 113 140 565
- US-A1- 2022 045 052
- US-A1- 2022 165 860
- US-A1- 2022 293 759

## Description

### 1. TECHNICAL FIELD

The present inventive concept relates to an integrated circuit device including a field-effect transistor.

### 2. DISCUSSION OF RELATED ART

The down-scaling of integrated circuit devices has rapidly increased as the electronics technology industry has developed. The demand for semiconductor devices that provide a high operating speed as well as operational accuracy has increased. Research is being conducted to optimize the structure of a transistor included in the semiconductor device so that the semiconductor device may provide an increased operational speed and accuracy. WO 2018/039645 discloses integrated circuit cell architectures including both front-side and back-side structures. One or more of back-side implant, semiconductor deposition, dielectric deposition, metallization, film patterning, and wafer-level layer transfer is integrated with front-side processing. Such double-side processing may entail revealing a back side of structures fabricated from the front-side of a substrate. Host-donor substrate assemblies may be built-up to support and protect front-side structures during back-side processing. Front-side devices, such as FETs, may be modified and/or interconnected during back-side processing. Back-side devices, such as FETs, may be integrated with front-side devices to expand device functionality, improve performance, or increase device density.

Document CN 113140565 A discloses a gate-all-around (GAA) transistor device comprising a dielectric layer on a substrate, and further comprising a conductive member connected to an epitaxial source/ drain region via a power rail contact. The power rail contact is electrically coupled to the backside of the epitaxial source/drain region.

Document US 2022/165860 A1 discloses a gate-all-around (GAA) transistor device in which a semiconductor plug located beneath a source/drain region is converted into a metal silicide, thereby forming a backside source/drain contact that is electrically conductive.

Gate-all-around (GAA) devices provided with backside contacts are furthermore known from EP 3 940 761 A1, US 2022/045052 A1 and US 2022/293759 A1.

### SUMMARY

Embodiments of the present inventive concept provide an integrated circuit device including a field effect transistor with increased integration and electrical reliability of the integrated circuit device.

According to an embodiment of the present invention as defined in independent claims 1 or 4, an integrated circuit device includes a back side interconnection structure extending in a first horizontal direction. An active substrate includes a fin-type active area extending in the first horizontal direction on the back side interconnection structure. A metal silicide film is between the back side interconnection structure and the active substrate. A plurality of gate structures extends in a second horizontal direction perpendicular to the first horizontal direction on the active substrate. A first source/drain area and a second source/drain area are spaced apart from each other in the first horizontal direction with a gate structure therebetween on the active substrate. The first source/drain area directly contacts the active substrate. The second source/drain area is spaced apart from the active substrate and insulated from the active substrate.

According to one embodiment of the present inventive concept, a lower insulating structure is on the back side interconnection structure and a lower contact structure penetrates the lower insulating structure and electrically connects the active substrate to the back side interconnection structure.

A plurality of nanosheet stacks is disposed on the fin-type active area and is surrounded by the plurality of gate structures. A first source/drain area and a second source/drain area are respectively disposed in first and second recesses that are spaced apart from each other and are defined in the active substrate. The plurality of nanosheet stacks are disposed on the active substrate and is positioned between the first source/drain area and the second source/drain area. A source/drain insulating structure is disposed between the second source/drain area and the active substrate in the second recess.

According to a first aspect of the invention, as defined in claim 1, the second source/drain area is spaced apart from the active substrate by a source/drain insulating structure that is disposed under the second source/drain area and above the active substrate.

According to a second aspect of the invention, as defined in claim 4, a source/drain insulating structure overlaps the second source/drain area in a vertical direction and penetrates the active substrate in the vertical direction.

At least some of the above and other features of the invention are set out in the claims.

### BRIEF DESCRIPTION OF THE DRAWINGS

Embodiments of the present inventive concept will be more clearly understood from the following detailed description taken in conjunction with the accompanying drawings in which:
FIG. 1 is a plan layout diagram of some components of an integrated circuit device according to an embodiment of the present inventive concept;
FIG. 2A is a cross-sectional view taken along line A-A' of FIG. 1, FIG. 2B is a cross-sectional view taken along line B-B' of FIG. 1, and FIG. 2C is a cross-sectional view taken along line C-C' of FIG 1 according to embodiments of the present inventive concept;
FIG. 3A is a cross-sectional view taken along line A-A' of FIG. 1, FIG. 3B is a cross-sectional view taken along line B-B' of FIG. 1, and FIG. 3C is a cross-sectional view taken along line C-C' of FIG 1 according to embodiments of the present inventive concept;
FIG. 4 is a cross-sectional view of an integrated circuit device according to an embodiment of the present inventive concept, corresponding to a cross-sectional view taken along the line C-C' of FIG. 1;
FIG. 5 is a cross-sectional view of an integrated circuit device according to an embodiment of the present inventive concept, corresponding to a cross-sectional view taken along line C-C' of FIG. 1;
FIG. 6 is a cross-sectional view of an integrated circuit device according to an embodiment of the present inventive concept, corresponding to the cross-sectional view taken along line B-B' of FIG. 1;
FIG. 7 is a cross-sectional view of an integrated circuit device according to an embodiment of the present inventive concept, corresponding to the cross-sectional view taken along line B-B' of FIG. 1;
FIGS. 8A to 8J are cross-sectional views of an unclaimed process sequence to explain a manufacturing method of an integrated circuit device according to embodiments of the present inventive concept, and show cross-sectional views along lines A-A' and C-C' of FIG. 1;
FIGS. 9A to 9C are cross-sectional views of an unclaimed process sequences to explain a method of manufacturing the integrated circuit device shown in FIG. 4 according to embodiments of the present inventive concept, and show a cross-sectional views along the line C-C' in FIG. 1; and
FIGS. 10A to 10C are cross-sectional views taken of an unclaimed process order to explain a method of manufacturing the integrated circuit device shown in FIG. 5 according to embodiments of the present inventive concept, and show a cross-sectional view taken along the line C-C' of FIG. 1.

### DETAILED DESCRIPTION OF EMBODIMENTS

Hereinafter, embodiments of the present inventive concept will be described in detail with reference to the accompanying drawings. The same reference numerals are used for the same components in the drawings, and duplicate descriptions thereof are omitted.

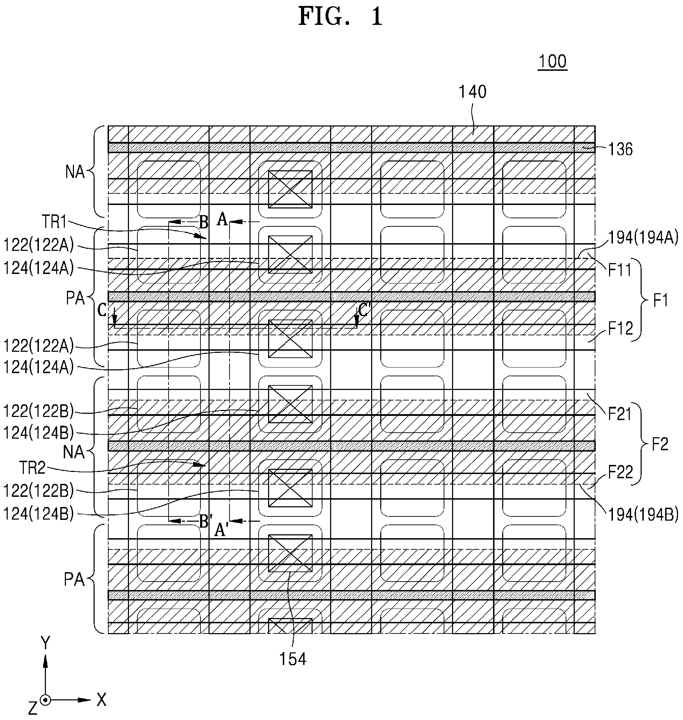

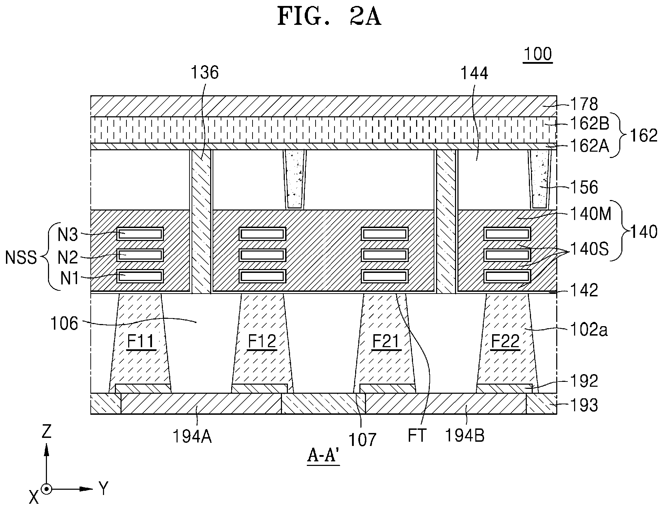

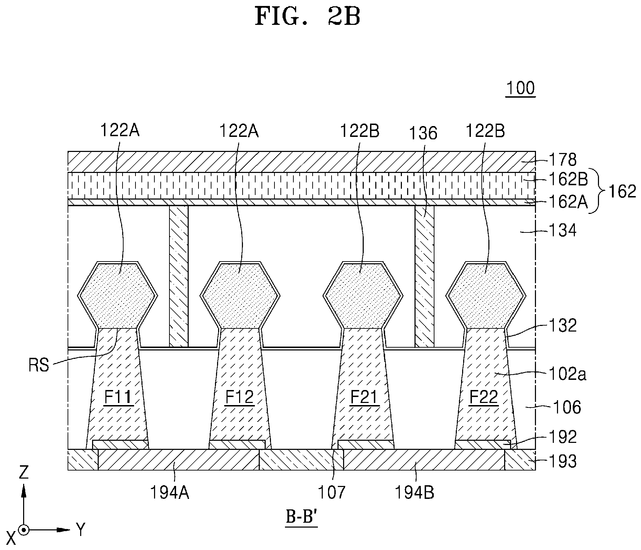

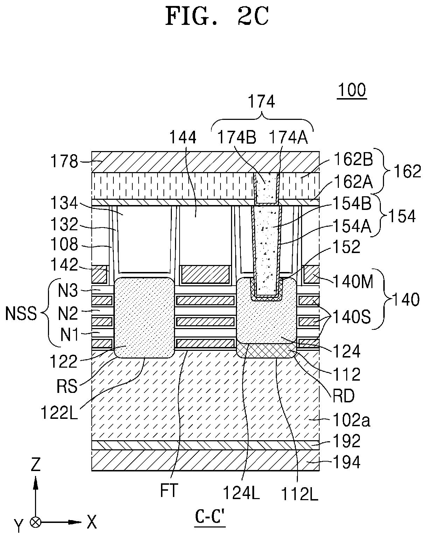

FIG. 1 is a plan layout diagram of some components of an integrated circuit device 100 according to an embodiment of the present inventive concept. FIG. 2A is a cross-sectional view taken along line A-A' of FIG. 1, FIG. 2B is a cross-sectional view taken along line B-B' of FIG. 1, and FIG. 2C is a cross-sectional view taken along line C-C' of FIG. 1. In embodiments described below with reference to FIGS. 1 to 2C, the integrated circuit device 100 may configure a logic cell including a multi-bridge channel field effect transistor (MBCFET) device. However, embodiments of the present inventive concept is not necessarily limited thereto, and the integrated circuit device 100 may include a two-dimensional material-based FET device or the like, such as planar field effect transistor (FET) devices, gate-all-around type FET devices, finFET devices, and MoS₂ semiconductor gate electrodes.

Referring to FIGS. 1 and 2A to 2C, the integrated circuit device 100 may include a plurality of first fin-type active areas F1 and a plurality of second fin-type active areas F2 extending in a first horizontal direction (X direction) on an active substrate 102a. According to an embodiment, the plurality of fin-type active areas F1 and F2 may be the active substrate 102a having a fin shape. As discussed herein, a horizontal direction (e.g. X direction or Y direction) may be any direction that is parallel to an upper surface of the active substrate 102a. Similarly a vertical direction (e.g. Z direction) may be a direction perpendicular to the upper surface of the active substrate 102a (e.g. perpendicular to the X direction and Y direction).

According to an embodiment, the integrated circuit device 100 may include a plurality of P-channel metal oxide semiconductor (PMOS) transistor areas PA and a plurality of N-channel metal oxide semiconductor (NMOS) transistor areas NA. In an embodiment, the first fin-type active area F1 may be included in the PMOS transistor area PA, and the second fin-type active area F2 may be included in the NMOS transistor area NA. According to an embodiment, the plurality of PMOS transistor areas PA and the plurality of NMOS transistor areas NA may be alternately disposed in a second horizontal direction (Y direction) perpendicular to the first horizontal direction (X direction). However, embodiments of the present disclosure are not necessarily limited thereto and the second horizontal direction (e.g., the Y direction) may cross the first horizontal direction (e.g., the X direction) at various different angles. According to an embodiment, the first fin-type active area F1 may include a third fin-type active area F11 and a fourth fin-type active area F12 extending parallel to each other (e.g., in the X direction) in the PMOS transistor area PA. For example, the third fin-type active area F11 and the fourth fin-type active area F12 may be spaced apart from each other in the Y direction with a device isolation film 106 therebetween. According to an embodiment, the second fin-type active area F2 may include a fifth fin-type active area F21 and a sixth fin-type active area F22 extending parallel to each other in the X direction in the NMOS transistor area NA. According to an embodiment, the fifth fin-type active area F21 may be spaced apart from the sixth fin-type active area F22 in the Y direction with the device isolation film 106 therebetween. Each of the third fin-type active area to sixth fin-type active areas F11 to F22 may be independent active substrates separated by the device isolation film 106. That is, each of the third to sixth fin-type active areas F11 to F22 may be separated from each other by the device isolation film 106 such that there are no active substrates or active areas connecting the third to sixth fin-type active areas F11 to F22.

According to an embodiment, the active substrate 102a may be a semiconductor substrate having a high impurity concentration. For example, the impurity concentration may be about 10¹⁵ to about 10²⁰ dopant atoms per cubic centimeter (cm⁻³), however, embodiments of the present inventive concept are not necessarily limited thereto. The active substrate 102a is a semiconductor substrate doped with a p-type dopant or an n-type dopant. According to an embodiment, the semiconductor substrate may include a group IV semiconductor such as Si or Ge, a group IV-IV compound semiconductor such as SiGe or SiC, or a group III-V compound semiconductor such as GaAs, InAs, or InP. The terms "SiGe", "SiC", "GaAs", "InAs", "InGaAs", and "InP" as used herein mean a material composed of elements included in each term, and are not a chemical formula representing a stoichiometric relationship. In an embodiment, the p-type dopant may be selected from boron (B) and gallium (Ga). In an embodiment, the n-type dopant may be selected from phosphorus (P), arsenic (As), and antimony (Sb). According to an embodiment, active substrates 102a of the plurality of first fin-type active areas F1 may have a p-type conductivity, and active substrates 102a of the plurality of second fin-type active areas F2 may have n-type conductivity.

According to an embodiment, the device isolation film 106 may be disposed between the plurality of fin-type active areas F1 and F2 (e.g., in the Y direction). According to an embodiment, the device isolation film 106 may be formed of an oxide film, a nitride film, or a combination thereof.

According to an embodiment, a plurality of gate structures 140 may be disposed on the plurality of fin-type active areas F1 and F2. According to an embodiment, each of the plurality of gate structures 140 may extend longitudinally in the second horizontal direction (Y direction). According to an embodiment, in areas in which the plurality of fin-type active areas F1 and F2 intersect with the plurality of gate structures 140, a plurality of nanosheet stacks NSS may be disposed on the fin upper surface FT of each of the plurality of fin-type active areas F1 and F2. According to an embodiment, the plurality of nanosheet stacks NSS may face the fin upper surfaces FT at positions spaced apart from the plurality of fin-type active areas F1 and F2 in a vertical direction (e.g., the Z direction). The term "nanosheet" as used in the present specification may refer to a conductive structure having a cross-section substantially perpendicular to a direction in which an electric current flows. The cross-section may have a thickness ranging from 1 to 100 nm. For example, the nanosheet may include nanowires.

According to an embodiment, the plurality of nanosheet stacks NSS may include a plurality of nanosheets N1, N2, and N3 overlapping each other in the Z direction on the fin upper surface FT of a plurality of fin-type active areas F1 and F2. The plurality of nanosheets N1, N2, and N3 may have different distances in the Z direction from the upper surface FT of the fin-type active areas F1 and F2. In an embodiment, the plurality of nanosheets N1, N2, and N3 may include first nanosheets N1, N2, and N3 sequentially stacked on the fin upper surfaces FT of the fin-type active areas F1 and F2. However, embodiments of the present inventive concept are not necessarily limited thereto and the number of nanosheets included in the plurality of nanosheets may vary.

According to an embodiment, a plurality of first recesses RS and a plurality of second recesses RD may be formed in the plurality of fin-type active areas F1 and F2. According to an embodiment, the plurality of first recesses RS may be arranged in the Y direction between two adjacent gate structures 140. According to an embodiment, the plurality of second recesses RD may be spaced apart from the plurality of first recesses RS (e.g., in the X direction) and may be arranged in the Y direction between two adjacent gate structures 140.

According to an embodiment, a plurality of first source/drain areas 122 may be disposed in the plurality of first recesses RS and a plurality of second source/drain areas 124 may be disposed in the plurality of second recesses RD. According to an embodiment, the plurality of first source/drain areas 122 may directly contact the active substrate 102a, and accordingly, the plurality of first source/drain areas 122 may be electrically connected to the active substrate 102a according to a driving of the integrated circuit device 100. According to an embodiment, the plurality of second sources/drain areas 124 may be spaced apart from the active substrate 102a (e.g., in the Z direction). According to the invention, the second source/drain area 124 is electrically insulated from the active substrate 102a According to the invention, the first source/drain area is disposed in a first recess defined in the active substrate between the plurality of nanosheet stacks, and the second source/drain area is disposed in a second recess defined in the active substrate between the plurality of nanosheet stacks. The second source/drain area is spaced apart from the active substrate by a source/drain insulating structure 112 that is disposed under the second source/drain area and above the active substrate.

According to an embodiment, a plurality of first source/drain insulating structures 112 respectively covering lower surfaces of the plurality of second recesses RD may be disposed in the plurality of second recesses RD, and a plurality of second source/drain areas 124 may be respectively disposed on the plurality of first source/drain insulating structures 112. According to an embodiment, the plurality of second source/drain areas 124 may be spaced apart from the plurality of fin-type active areas F1 and F2 with the plurality of first source/drain insulating structures 112 therebetween (e.g., in the Z direction). For example, the plurality of first source/drain insulating structures 112 may be disposed under the plurality of second source/drain areas 124 and above the active substrate 102a. According to an embodiment, the first source/drain insulating structure 112 may be an insulating material layer made of oxide, nitride, or a combination thereof. According to an embodiment, the first source/drain insulating structure 112 may have a conformal thickness following a profile of a lower surface of the second recess RD. However, embodiments of the present inventive concept are not necessarily limited thereto. According to an embodiment, the sidewall of the first source/drain insulating structure 112 may face a lowermost sub gate portion 140S of the gate structure 140, for example, the sub gate portion 140S disposed under the nanosheet N1 at the bottom of the nanosheet stack NSS, with a gate dielectric film 142 therebetween, as described later.

According to an embodiment, lower surfaces 112L of the plurality of first source/drain insulating structures 112 may be located at a lower level than the upper surfaces FT of the plurality of fin-type active areas F1 and F2 in the Z direction, and lower surfaces 124L of the plurality of second sources/drain areas 124 may be located at a level higher than the upper surfaces FT of the plurality of fin-type active areas F1 and F2 in the Z direction. For example, the lower surface 124L of the plurality of second source/drain areas 124 may be disposed at a level lower than the bottom surface of the lowest nanosheet (e.g., the first nanosheet N1) of the nanosheet stack NSS. For example, entire bottom surfaces of the plurality of second source/drain areas 124 may be respectively disposed on (e.g., disposed directly thereon in the Z direction) the plurality of first source/drain insulating structures 112, and the plurality of second source/drain areas 124 and the plurality of fin-type active areas F1 and F2 may be electrically insulated from each other.

According to an embodiment, the plurality of first sources/drain areas 122 may include a plurality of third sources/drain areas 122A disposed in the PMOS transistor area PA, and a plurality of fourth source/drain areas 122B disposed in the NMOS transistor area NA. According to an embodiment, the plurality of second sources/drain areas 124 may include a plurality of fifth sources/drain areas 124A disposed in the PMOS transistor area PA, and a plurality of sixth source/drain areas 124B disposed in the NMOS transistor area NA.

In some embodiments, the plurality of third source/drain areas 122A and fifth source/drain areas 124A may be formed of a semiconductor layer doped with a p-type dopant. For example, the semiconductor layer may include a semiconductor such as Si or Ge, or a compound semiconductor such as SiGe, SiC, GaAs, InAs, InGaAs, or InP. For example, the p-type dopant may be selected from boron (B) and gallium (Ga).

In some embodiments, the plurality of fourth source/drain areas 122B and sixth source/drain areas 124B may be formed of a semiconductor layer doped with an n-type dopant. For example, the semiconductor layer may include a semiconductor such as Si or Ge, or a compound semiconductor such as SiGe, SiC, GaAs, InAs, InGaAs, or InP. For example, the n-type dopant may be selected from phosphorus (P), arsenic (As), and antimony (Sb).

According to an embodiment, the first source/drain area 122 may be formed of a semiconductor material doped with the same conductivity as that of the active substrate 102a. According to an embodiment, the first source/drain area 122 may have an integral structure with the active substrate 102a.

According to an embodiment, each of the plurality of first sources/drain areas 122 and the plurality of second sources/drain areas 124 may be arranged at a position adjacent to at least one gate structure 140 selected from among a plurality of gate structures 140. According to an embodiment, each of the plurality of first sources/drain areas 122 and the plurality of second sources/drain areas 124 may have sidewalls facing the first nanosheet N1, the second nanosheet N2, and the third nanosheet N3 included in the nanosheet stack NSS adjacent to the plurality of first sources/drain areas 122 and the plurality of second sources/drain areas 124. The plurality of first sources/drain areas 122 and the plurality of second sources/drain areas 124 be in direct contact with the first nanosheet N1, the second nanosheet N2, and the third nanosheet N3, respectively. As shown in FIG. 2C, the lower surfaces 124L of the plurality of second sources/drain areas 124 may be located at a higher level than the lower surfaces 122L of the plurality of first sources/drain areas 122 in the Z direction. According to an embodiment, the lower surfaces 124L of the plurality of second source/drain areas 124 may be disposed at a level lower than the bottom surface of the first nanosheet N1 in the Z direction. According to an embodiment, each of the plurality of second sources/drain areas 124 may be connected to an end (e.g., a sidewall) of all of the first nanosheets N1, the second nanosheets N2, and the third nanosheets N3.

According to an embodiment, PMOS transistors TR1 may be formed at portions where the plurality of first fin-type active areas F1 and the plurality of gate structures 140 intersect each other in the PMOS transistor area PA, respectively, and NMOS transistors TR2 may be formed at portions where the plurality of second fin-type active areas F2 and the plurality of gate structures 140 intersect each other in the NMOS transistor area NA, respectively.

According to an embodiment, some of the plurality of fin-type active areas F1 and F2 may be arranged at a constant pitch. Pitch may represent a separation distance between adjacent features (in this case, adjacent fin-type active areas F1 and F2). According to an embodiment, other portions of the plurality of fin-type active areas F1 and F2 are formed at a variable pitch so that the separation distance between the two adjacent fin-type active areas F1 and F2 may vary depending on the location.

According to an embodiment, each of the plurality of gate structures 140 may include a main gate portion 140M and a plurality of sub gate portions 140S. According to an embodiment, the main gate portion 140M may extend longitudinally in the Y direction and cover the upper surface of the nanosheet stack NSS. According to an embodiment, the plurality of sub gate portions 140S may be integrally connected to the main gate portion 140M, and each may be disposed between each of the plurality of nanosheets N1, N2, and N3 and between the fin-type active areas F1 and F2 and the first nanosheet N1.

According to an embodiment, each of the plurality of gate structures 140 may be made of metal, metal nitride, metal carbide, or a combination thereof. The metal may include Ti, W, Ru, Nb, Mo, Hf, Ni, Co, Pt, Yb, Tb, Dy, Er, Pd, and combinations thereof. For example, the metal nitride may be selected from TiN and TaN. For example, the metal carbide may be TiAlC. However, embodiments of the present inventive concept are not necessarily limited thereto and the material of the plurality of gate structures 140 may vary.

According to an embodiment, a plurality of gate cut insulating patterns 136 may be disposed on the device isolation film 106. According to an embodiment, the plurality of gate cut insulating patterns 136 may extend in the X direction to intersect with the plurality of gate structures 140. In FIG. 2A, the lower surface of the gate cut insulating pattern 136 is shown to be positioned at the same level as the fin upper surfaces FT of the fin-type active areas F1 and F2 in the Z direction. However, embodiments of the present inventive concept are not necessarily limited thereto. For example, in some embodiments the gate cut insulating pattern 136 may penetrate the device isolation film 106, and the lower surface of the gate cut insulating pattern 136 may be positioned at a level lower than the upper surface FT of the fins of the fin-type active areas F1 and F2 in the Z direction. In FIG. 2B, the lower surface of the gate cut insulating pattern 136 is shown as being in direct contact with the upper surface of the insulating liner 132. However, embodiments of the present inventive concept are not necessarily limited thereto. For example, in some embodiments the lower surface of the gate cut insulating pattern 136 may be positioned at a lower level than the lower surface of the insulating liner 132 in the Z direction (e.g. gate cut insulating pattern 136 may penetrate the insulating liner 132).

According to an embodiment, the plurality of gate cut insulating patterns 136 may penetrate the plurality of gate structures 140 in the Z direction. In some embodiments, the uppermost surfaces of the plurality of gate cut insulating patterns 136 may be positioned at a higher level than the uppermost surfaces of the plurality of gate structures 140 in the Z direction. For example, in an embodiment the plurality of gate cut insulating patterns 136 may pass through the capping insulating pattern 144 covering the plurality of gate structures 140, and the uppermost surface level of the plurality of gate cut insulating patterns 136 may be the same as or similar to that of the capping insulating pattern 144. In some other embodiments, the uppermost surface level of each of the plurality of gate cut insulating patterns 136 may be the same as or similar to the uppermost surface level of the plurality of gate structures 140.

According to an embodiment, in the Y direction, a pair of gate structures 140 disposed adjacent to both sides with each of the plurality of gate cut insulating patterns 136 therebetween may be spaced apart from each other without being connected to each other. For example, among the plurality of gate structures 140, the plurality of gate structures 140 arranged in a line in the Y direction may be spaced apart from each other by the plurality of gate cut insulating patterns 136. That is, each gate cut insulating pattern 136 may insulate the adjacent pair of gate structures 140 from each other.

According to an embodiment, within the PMOS transistor area PA, the third fin-type active area F11 and the fourth fin-type active area F12 may be spaced apart from each other in the Y direction with the gate cut insulating pattern 136 therebetween. According to an embodiment, within the PMOS transistor area PA, the plurality of third source/drain areas 122A may be spaced apart from each other in the Y direction with the gate cut insulating pattern 136 therebetween, and the plurality of fifth source/drain areas 124A may be spaced apart from each other in the Y direction with the gate cut insulating pattern 136 therebetween. For example, the third fin-type active area F11, the third source/drain area 122A, and the fifth source/drain area 124A may have a mirror-symmetrical structure with the fourth fin-type active area F12, the third source/drain area 122A, and the fifth source/drain area 124A spaced apart in the Y direction with the gate cut insulating pattern 136 therebetween.

According to an embodiment, within the NMOS transistor area NA, the third fin-type active area F21 and the fourth fin-type active area F22 may be spaced apart from each other in the Y direction with the gate cut insulating pattern 136 therebetween. According to an embodiment, within the NMOS transistor area NA, the plurality of fourth source/drain areas 122B may be spaced apart from each other in the Y direction with the gate cut insulating pattern 136 therebetween, and the plurality of sixth source/drain areas 124B may be spaced apart from each other in the Y direction with the gate cut insulating pattern 136 therebetween. For example, the fifth fin-type active area F21, the fourth source/drain area 122B, and the sixth source/drain area 124B may have a mirror-symmetrical structure with the sixth fin-type active area F22, the fourth source/drain area 122B, and the sixth source/drain area 124B spaced apart in the Y direction with the gate cut insulating pattern 136 therebetween.

According to an embodiment, the plurality of gate cut insulating patterns 136 may include an oxide film, a nitride film, or a combination thereof. According to an embodiment, the plurality of gate cut insulating patterns 136 may be formed of an insulating film containing nitrogen. For example, the plurality of gate cut insulating patterns 136 may be formed of a silicon nitride film. However, embodiments of the present inventive concept are not necessarily limited thereto and the material of the plurality of gate cut insulating patterns 136 may vary.

According to an embodiment, a gate dielectric film 142 may be disposed between the plurality of nanosheets N1, N2, and N3 constituting the nanosheet stack NSS and the gate structure 140. According to an embodiment, the gate dielectric film 142 may include portions covering surfaces of each of the plurality of nanosheets N1, N2, and N3, portions covering sidewalls of the main gate portion 140M, and portions covering sidewalls of the plurality of gate cut insulating patterns 136.

According to an embodiment, the gate dielectric film 142 may include a stacked structure of an interface film and a high dielectric film. In an embodiment, the interface film may be formed of a low-k material film having a dielectric constant of about 9 or less, for example, a silicon oxide film, a silicon oxide nitride film, or a combination thereof. However, embodiments of the present inventive concept are not necessarily limited thereto. For example, in an embodiment, the interface film may be omitted. According to an embodiment, the high dielectric film may be made of a material having a higher dielectric constant than the silicon oxide film. For example, the high dielectric film may have a dielectric constant in a range of about 10 to about 25. The high dielectric film may be made of hafnium oxide. However, embodiments of the present inventive concept are not necessarily limited thereto.

According to an embodiment, the plurality of nanosheets N1, N2, and N3 may be formed of semiconductor layers made of the same element. According to an embodiment, each of the plurality of nanosheets N1, N2, and N3 may include a Si layer or a SiGe layer. For example, in the NMOS transistor area NA, each of the plurality of nanosheets N1, N2, and N3 may be formed of a Si layer, and in the PMOS transistor area PA, each of the plurality of nanosheets N1, N2, and N3 may be formed of a SiGe layer. According to an embodiment, in the PMOS transistor area PA, the plurality of nanosheets N1, N2, and N3 may be doped with a p-type dopant. According to an embodiment, in the NMOS transistor area NA, the plurality of nanosheets N1, N2, and N3 may be doped with an n-type dopant.

According to an embodiment, on a plurality of fin-type active areas F1 and F2 and the device isolation film 106, both sidewalls of each of the plurality of gate structures 140 may be covered with a plurality of outer insulating spacers 108. According to an embodiment, the plurality of outer insulating spacers 108 may cover both sidewalls of the main gate portion 140M on top of the plurality of nanosheet stacks NSS. According to an embodiment, each of the plurality of outer insulating spacers 108 may be spaced apart from the gate structure 140 (e.g., in the X direction) with the gate dielectric film 142 therebetween. According to an embodiment, the plurality of outer insulating spacers 108 may be formed of silicon nitride, silicon oxide, SiCN, SiBN, SiON, SiOCN, SiBCN, SiOC, or a combination thereof. The terms "SiCN", "SiBN", "SiON", "SiOCN", "SiBCN", and "SiOC" as used herein refer to a material composed of elements included in each term, and are not a chemical formula representing a stoichiometric relationship.

According to an embodiment, between each of the plurality of nanosheets N1, N2, and N3 and between the second fin-type active area F2 and the first nanosheet N1, both sidewalls of each of the plurality of sub gate portions 140S may be spaced apart from the first and second source/drain areas 122 and 124 (e.g., in the X direction) with the gate dielectric film 142 therebetween. According to an embodiment, the gate dielectric film 142 may include portions in direct contact with the first and second source/drain areas 122 and 124. According to an embodiment, the plurality of first and second sources/drain areas 122 and 124 may face the nanosheet stack NSS and the plurality of sub gate portions 140S in the X direction, respectively.

According to an embodiment, each of the plurality of gate structures 140 may have a structure in which a metal nitride film, a metal film, a conductive capping film, and a gap-fill metal film are sequentially stacked (e.g., in the Z direction). For example, in an embodiment the metal nitride film and the metal film may include at least one metal selected from Ti, Ta, W, Ru, Nb, Mo, and Hf. For example, the gap-fill metal film may be formed of a W film or an Al film. According to an embodiment, each of the plurality of gate structures 140 may include at least one work function metal-containing film. For example, the at least one work function metal containing film may include at least one metal selected from Ti, W, Ru, Nb, Mo, Hf, Ni, Co, Pt, Yb, Tb, Dy, Er, and Pd. In some embodiments, each of the plurality of gate structures 140 may include a TiAlC/TiN/W stack structure, a TiN/TaN/TiAlC/TiN/W stack structure, or a TiN/TaN/TiN/TiAlC/TiN/W stack structure. However, embodiments of the present inventive concept are not necessarily limited to the above examples.

According to an embodiment, the gate structure 140 and the gate dielectric film 142 covering sidewalls of the gate structure 140 may be covered with a capping insulating pattern 144. For example, in an embodiment the capping insulating pattern 144 may be made of a silicon nitride film. However, embodiments of the present inventive concept are not necessarily limited thereto. For example, in some other embodiments, the capping insulating pattern 144 may be omitted. In this embodiment, the upper surface of the main gate portion 140M may directly contact the lower surface of the upper insulating structure 162.

According to an embodiment, the main gate portion 140M of the gate structure 140 may be spaced apart from the first and second source/drain areas 122 and 124 with the outer insulating spacer 108 therebetween.

According to an embodiment, in the PMOS transistor area PA and the NMOS transistor area NA, the plurality of first and second source/drain areas 122 and 124 may be covered by the insulating liner 132. According to an embodiment, the insulating liner 132 may conformally cover surfaces of each of the plurality of first and second source/drain areas 122 and 124 and the outer insulating spacer 108. According to an embodiment, the insulating liner 132 may be made of SiN, SiCN, SiBN, SiON, SiOCN, SiBCN, SiOC, SiO₂, or a combination thereof. However, embodiments of the present inventive concept are not necessarily limited thereto.

According to an embodiment, in the PMOS transistor area PA and the NMOS transistor area NA, the insulating liner 132 may be covered with an inter-gate insulating film 134. According to an embodiment, the inter-gate insulating film 134 may be formed of a silicon nitride film, a silicon oxide film, SiON, SiOCN, or a combination thereof. However, embodiments of the present inventive concept are not necessarily limited thereto.

According to an embodiment, the plurality of capping insulating patterns 144 and the inter-gate insulating film 134 between each of the plurality of capping insulating patterns 144 may be covered with the upper insulating structure 162. In an embodiment, the upper insulating structure 162 may include an etch stop film 162A and an interlayer insulating film 162B. In an embodiment, the etch stop film 162A may be formed of silicon carbide (SiC), SiN, nitrogen-doped silicon carbide (SiC:N), SiOC, AIN, AlON, AlO, AlOC, or a combination thereof. The interlayer insulating film 162B may be formed of an oxide film, a nitride film, an ultra low-k (ULK) film having an ultra low dielectric constant K in a range of about 2.2 to about 2.4, or a combination thereof. For example, the interlayer insulating film 162B may be formed of a TEOS (tetraethylorthosilicate) film, a high density plasma (HDP) film, a boro-phospho-silicate glass (BPSG) film, a flowable chemical vapor deposition (FCVD) oxide film, a SiON film, a SiN film, a SiOC film, a SiCOH film, or a combination thereof.

According to an embodiment, in the PMOS transistor area PA and the NMOS transistor area NA, a plurality of first contact structures 154 and a via structure 174 may be disposed on the plurality of second source/drain areas 124. According to an embodiment, the plurality of second sources/drain areas 124 may be connected to the upper front side interconnection structure 178 through the plurality of first contact structures 154 and the plurality of via structures 174. According to an embodiment, the front side interconnection structure 178 may include a wiring layer made of W, Co, Cu, Ru, Mn, Ti, Ta, TiN, TaN, or a combination thereof. The front side interconnection structure 178 is illustratively shown as being composed of a single layer. However, embodiments of the present inventive concept are not necessarily limited thereto and the front side interconnection structure 178 may be formed as a multi-layered structure including wiring layers composed of two layers, three layers, or four or more layers, and vias connecting the wiring layers.

According to an embodiment, a first metal silicide film 152 may be formed between the second source/drain area 124 and the first contact structure 154. According to an embodiment, the first metal silicide film 152 may include Ti, W, Ru, Nb, Mo, Hf, Ni, Co, Pt, Yb, Tb, Dy, Er, or Pd. For example, the first metal silicide film 152 may be made of titanium silicide. According to an embodiment, the first contact structure 154 may directly contact the first metal silicide film 152 by penetrating the inter-gate insulating film 134 and the insulating liner 132 in the Z direction. According to an embodiment, the plurality of via structures 174 may penetrate the upper insulating structure 162 in the Z direction and directly contact the upper surface of the first contact structure 154.

According to an embodiment, the plurality of first contact structures 154 may include a first conductive barrier film 154A and a first metal plug 154B. The plurality of via structures 174 may include a second conductive barrier film 174A and a second metal plug 174B. According to an embodiment, each of the first and second conductive barrier films 154A and 174A may be made of Ti, Ta, TiN, TaN, or a combination thereof. According to an embodiment, each of the first and second metal plugs 154B and 174B may be made of W, Co, Cu, Ru, Mn, or a combination thereof. According to an embodiment, sidewalls of each of the plurality of first contact structures 154 and the plurality of via structures 174 may be surrounded by contact insulating spacers. The contact insulating spacer may be made of SiCN, SiCON, silicon nitride (SiN), or a combination thereof. However, embodiments of the present inventive concept are not necessarily limited thereto.

According to an embodiment, a gate contact 156 may be formed on each of the plurality of gate structures 140. Each of the plurality of gate structures 140 may be connected to an upper front side interconnection structure 178 through the gate contact 156. The gate contact 156 may have a structure similar to that described for the first contact structure 154 and the via structure 174.

According to an embodiment, the active substrate 102a may have a lower surface 107 opposite to the upper surface FT of the fins (e.g., in the Z direction), and the integrated circuit device 100 may include the lower surface 107 of the active substrate 102a on the lower surface 107 of the active substrate 102a and a plurality of back side interconnection structures 194 extending parallel to each other in the X direction and partially covering the lower surface of the device isolation film 106. According to an embodiment, the back side interconnection structure 194 may include a power delivery network configured to apply a power supply voltage and a ground voltage to the plurality of PMOS and NMOS transistors TR1 and TR2. According to an embodiment, the plurality of back side interconnection structures 194 may be electrically insulated from each other by the first lower insulating structure 193. According to an embodiment, the first lower insulating structure 193 may be formed of an ultra low-k (ULK) film having an ultra low dielectric constant k in a range of about 2.2 to about 2.4, or a combination thereof.

According to an embodiment, the plurality of back side interconnection structures 194 may overlap the plurality of fin-type active areas F1 and F2 in the Z direction.

According to an embodiment, the plurality of back side conductive wiring structures 194 may include a first backside conductive wiring structure 194A disposed in the PMOS transistor area PA and a second backside conductive wiring structure 194B disposed in the NMOS transistor area NA. According to an embodiment, each of the first back side conductive wiring structure 194A and the second back side conductive wiring structure 194B may extend parallel to each other in the X direction in the PMOS transistor area PA and the NMOS transistor area NA. According to an embodiment, each of the third fin-type active area F11 and the fourth fin-type active area F12 of the PMOS transistor area PA may at least partially overlap the first back side conductive wiring structure 194A in the Z direction. According to an embodiment, each of the fifth fin-type active area F21 and the sixth fin-type active area F22 of the NMOS transistor area NA may at least partially overlap the second back side conductive wiring structure 194B in the Z direction.

According to an embodiment, a second metal silicide film 192 is formed between the back side interconnection structure 194 and the plurality of fin-type active areas F1 and F2. According to an embodiment, the second metal silicide film 192 may overlap the first source/drain area 122 in the Z direction.

According to an embodiment, the second metal silicide film 192 may extend in the X direction on the back side interconnection structure 194, and may cover at least a portion of the upper surface of the back side interconnection structure 194. According to an embodiment, the second metal silicide film 192 may overlap the second source/drain area 124 (e.g., in the Z direction). For example, the second metal silicide film 192 may cover an upper surface of a portion of the back side interconnection structure 194 that overlaps the plurality of fin-type active areas F1 and F2 in the Z direction.

According to an embodiment, the second metal silicide film 192 may include Ti, W, Ru, Nb, Mo, Hf, Ni, Co, Pt, Yb, Tb, Dy, Er, or Pd. For example, the second metal silicide film 192 may be made of titanium silicide. However, embodiments of the present inventive concept are not necessarily limited thereto.

According to an embodiment, the back side interconnection structure 194 may include a wiring layer made of W, Co, Cu, Ru, Mn, Ti, Ta, TiN, TaN, or a combination thereof. The back side interconnection structure 194 is illustratively shown as being composed of a single layer, but may be formed as a multi-layered structure including wiring layers composed of two layers, three layers, or more layers, and vias connecting the wiring layers.

According to an embodiment, the back side interconnection structure 194 is electrically connected to the first source/drain area 122 through the second metal silicide film 192 and the active substrate 102a. According to an embodiment, the first source/drain area 122 may serve as a source area, and the second source/drain area 124 may serve as a drain area. In this embodiment, the first source/drain area 122 is electrically connected to the back side interconnection structure 194 through the active substrate 102a and the second metal silicide film 192, and the second source/drain area 124 may be electrically connected to the front side interconnection structure 178 through the first contact structure 154 on the second source/drain area 124.

For example, the plurality of active fin areas F1 and F2 may be configured to serve as wires electrically connecting the back side interconnection structure 194 to the first source/drain area 122. The integrated circuit device 100 according to an embodiment of the present inventive concept may not include a separate contact for electrically connecting the back side interconnection structure 194 to the first source/drain area 122. For example, a vertical wiring, a vertical contact, or the like that comes into direct contact with the back side interconnection structure 194 and penetrates the semiconductor substrate, the gate structure, and the upper insulating structure in the Z direction may be omitted. Accordingly, wiring complexity of an integrated circuit device due to downscaling may be reduced, and resistance deterioration due to the introduction of a separate contact may be prevented, so that electrical reliability of the integrated circuit device 100 may be increased.

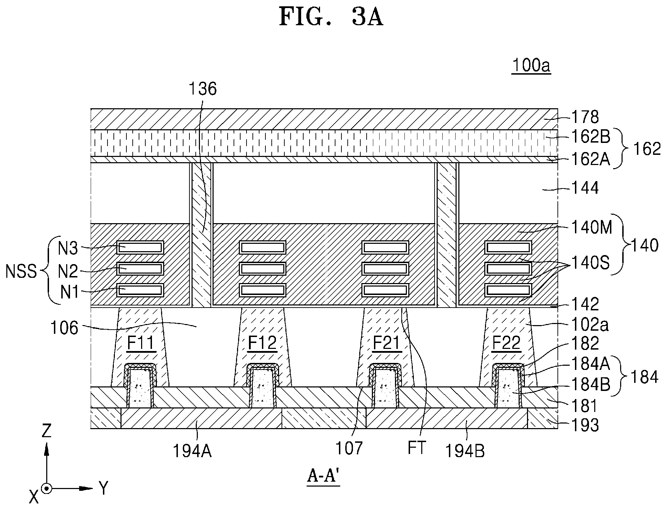

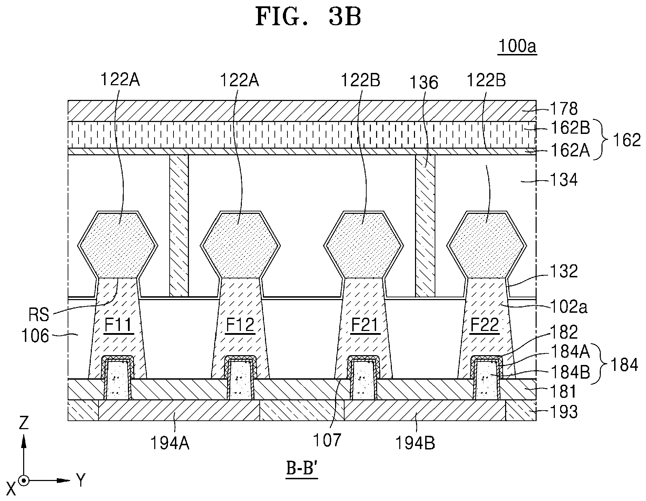

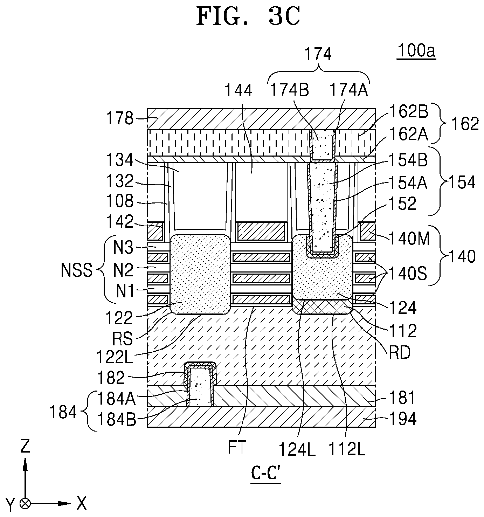

FIGS. 3A to 3C are cross-sectional views of an integrated circuit device 100a according to embodiments of the present inventive concept having the planar layout diagram of FIG. 1, and FIG. 3A is a cross-sectional view corresponding to the A-A' line cross-sectional view of FIG. 1, FIG. 3B is a cross-sectional view corresponding to the line B-B' of FIG. 1, and FIG. 3C is a cross-sectional view corresponding to the line C-C' of FIG. 1. A difference between embodiments of FIGS. 2A to 2C and FIGS. 3A to 3C is whether the second contact structure 184 is formed between the back side interconnection structure 194 and the active substrate 102a.

Referring to FIGS. 3A to 3C, a second lower insulating structure 181 covering the lower surface of the active substrate 102a and the lower surface of the device isolation film 106 may be disposed on the lower surface 107 of the active substrate 102a and a plurality of back side interconnection structures 194 and a first lower insulating structure 193 may be disposed on the lower surface of the second lower insulating structure 181. According to an embodiment, the plurality of back side interconnection structures 194 may be spaced apart from the active substrate 102a in the Z direction with the second lower insulating structure 181 disposed therebetween.

According to an embodiment, a second contact structure 184 may be disposed to extend through the second lower insulating structure 181 in the Z direction to connect the active substrate 102a and the plurality of back side interconnection structures 194 on a plurality of back side interconnection structures 194. In FIGS. 3A to 3C, the plurality of second contact structures 184 partially pass through the active substrate 102a and directly contact the active substrate 102a. However, embodiments of the present inventive concept are not necessarily limited thereto. For example, in an embodiment the plurality of second contact structures 184 may pass through the second lower insulating structure 181 and directly contact the active substrate 102a without partially passing through the active substrate 102a. According to an embodiment, the second lower insulating structure 181 may be made of silicon oxide, silicon nitride, or a combination thereof. However, embodiments of the present inventive concept are not necessarily limited thereto.

According to an embodiment, the plurality of second contact structures 184 may overlap the first source/drain area 122 in the Z direction. According to an embodiment, the plurality of second contact structures 184 may be in direct contact with the plurality of fin-type active areas F1 and F2 under the plurality of first source/drain areas 122 and disposed in the Y direction.

According to an embodiment, a third metal silicide film 182 may be disposed between the active substrate 102a and the second contact structure 184. According to an embodiment, the third metal silicide film 182 may include Ti, W, Ru, Nb, Mo, Hf, Ni, Co, Pt, Yb, Tb, Dy, Er, or Pd.

According to an embodiment, the plurality of second contact structures 184 may include a third conductive barrier film 184A and a third metal plug 184B. In an embodiment, the third conductive barrier film 184A may be made of Ti, Ta, TiN, TaN, or a combination thereof. According to an embodiment, the third metal plug 184B may be made of W, Co, Cu, Ru, Mn, or a combination thereof. According to an embodiment, sidewalls of the plurality of second contact structures 184 may be surrounded by contact insulating spacers. In an embodiment, the contact insulating spacer may be made of SiCN, SiCON, silicon nitride (SiN), or a combination thereof. However, embodiments of the present inventive concept are not necessarily limited thereto.

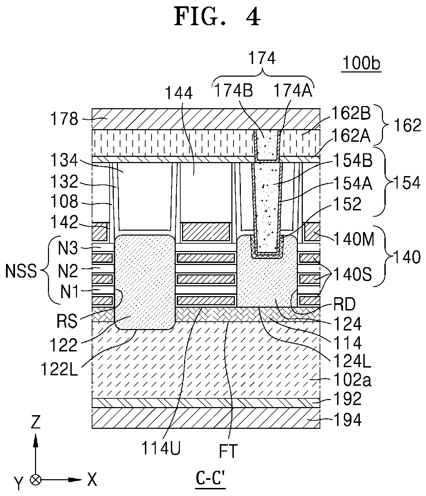

FIG. 4 is a cross-sectional view of an integrated circuit device 100b according to an embodiment of the present inventive concept, corresponding to a cross-sectional view taken along the line C-C' of FIG. 1. The difference between embodiments of FIG. 4 and FIG. 2C is whether the second source/drain area 124 is electrically isolated from the active substrate 102a via the second source/drain insulating structure 114.

Referring to FIG. 4, the second source/drain insulating structure 114 may be disposed on the upper surface of the active substrate 102a, and the second source/drain area 124 may be electrically insulated from the active substrate 102a through the second source/drain insulating structure 114.

According to an embodiment, the plurality of second source/drain insulating structures 114 may extend in the X direction on the upper surfaces FT of the plurality of fin-type active areas F1 and F2.

According to an embodiment, the first recess RS may pass through the second source/drain insulating structure 114, and the first source/drain area 122 may be disposed in the first recess RS. In this embodiment, the first source/drain area 122 may directly contact the active substrate 102a and may be electrically connected to the active substrate 102a when the integrated circuit device 100a is driven. According to an embodiment, the second recess RD may not penetrate the second source/drain insulating structure 114. For example, the lower surface 124L of the second source/drain area 124 may directly contact the upper surface 114U of the second source/drain insulating structure 114. The second source/drain areas 124 may be disposed between the active substrate 102a and the second source/drain insulating structure 114 (e.g., in the Z direction).

According to an embodiment, an upper surface 114U of the second source/drain insulating structure 114 may face the gate structure 140 with the gate dielectric film 142 therebetween (e.g., in the Z direction). According to an embodiment, upper surfaces FT of the plurality of fin-type active areas F1 and F2 may face the gate dielectric film 142 with the second source/drain insulating structure 114 therebetween (e.g., in the Z direction).

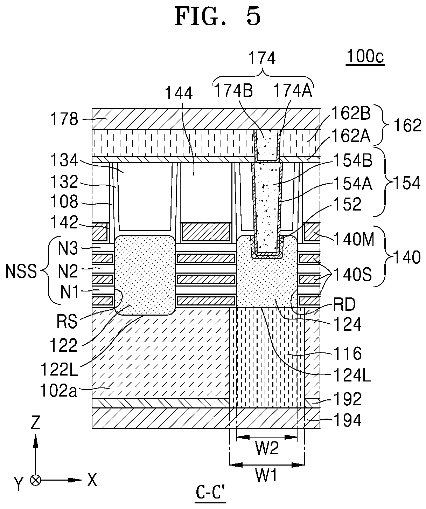

FIG. 5 is a cross-sectional view of an integrated circuit device 100c according to an embodiment of the present inventive concept, corresponding to a cross-sectional view taken along the line C-C' of FIG. 1. The difference between embodiments of FIG. 5 and FIG. 2C is whether the second source/drain area 124 is electrically insulated from the active substrate 102a through the third source/drain insulating structure 116.

Referring to FIG. 5, the third source/drain insulating structure 116 vertically penetrating the active substrate 102a (e.g., in the Z direction) is disposed on the lower surface 124L of the second source/drain area 124, and the second source/drain area 124 is electrically insulated from the active substrate 102a through the third source/drain insulating structure 116.

According to an embodiment, the plurality of third source/drain insulating structures 116 may be arranged in the Y direction under the second source/drain area 124.

According to an embodiment, the first width W1, which is the width of the third source/drain insulating structure 116 in a horizontal direction (e.g., the X direction and/or the Y direction), may be wider than the second width W2 of the second source/drain area 124 in a horizontal direction (e.g., the X direction and/or the Y direction). The first and second width W1 and W2 may be measured along the same horizontal direction (e.g. the X direction and/or the Y direction).

According to an embodiment, the second metal silicide film 192 may partially cover sidewalls of the third source/drain insulating structure 116 on the back side interconnection structure 194. For example, the third source/drain insulating structure 116 penetrates the second metal silicide film 192 and may directly contact the back side interconnection structure 194.

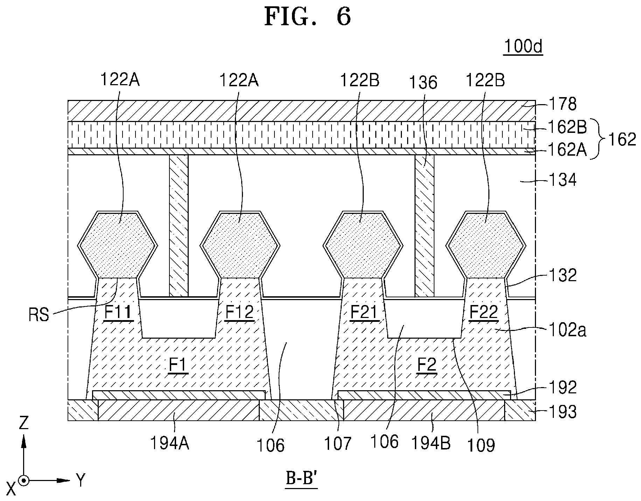

FIG. 6 is a cross-sectional view of an integrated circuit device 100d according to an embodiment of the present inventive concept, corresponding to the cross-sectional view taken along line B-B' of FIG. 1. The difference between embodiments of FIG. 6 and FIG. 2B is whether the plurality of third fin-type active areas F11 and the plurality of fourth fin-type active areas F12 are connected to each other, and the plurality of fifth fin-type active areas F21 and the plurality of sixth fin-type active areas F22 are connected to each other.

Referring to FIG. 6, the third fin-type active area F11 and the fourth fin-type active area F12 of the first fin-type active area F1 may have a shape protruding (e.g., in the Z direction) from the upper surface 109 of the active substrate 102a, and the fifth fin-type active area F21 and the sixth fin-type active area F22 of the second fin-type active area F2 may have a shape protruding (e.g., in the Z direction) from the upper surface 109 of the active substrate 102a.

According to an embodiment, the third fin-type active area F11 and the fourth fin-type active area F12 may be connected to each other through the active substrate 102a, and the fifth fin-type active area F21 and the sixth fin-type active area F22 may be connected to each other through the active substrate 102a. According to an embodiment, on the upper surface 109 of the active substrate 102a, a device isolation film 106 may be disposed between the third fin-type active area F11 and the fourth fin-type active area F12 and between the fifth fin-type active area F21 and the sixth fin-type active area F22. According to an embodiment, the first fin-type active area F1 and the second fin-type active area F2 may be spaced apart from each other in the Y direction with the device isolation film 106 therebetween.

According to an embodiment, the first fin-type active area F1 including the third fin-type active area F11 and the fourth fin-type active area F12 may be integrally formed and extend longitudinally in the X direction, and the second fin-type active area F2 including the fifth fin-type active area F21 and the sixth fin-type active area F22 may be integrally formed and extend longitudinally in the X direction.

According to an embodiment, the first back side interconnection structure 194A may entirely overlap the first fin-type active area F1 in the Z direction, and the second metal silicide film 192 may entirely cover the upper surface of the first back side conductive wiring structure 194A. According to an embodiment, the second back side interconnection structure 194B may entirely overlap the second fin-type active area F2 in the Z direction, and the second metal silicide film 192 may entirely cover the upper surface of the second back side conductive wiring structure 194B.

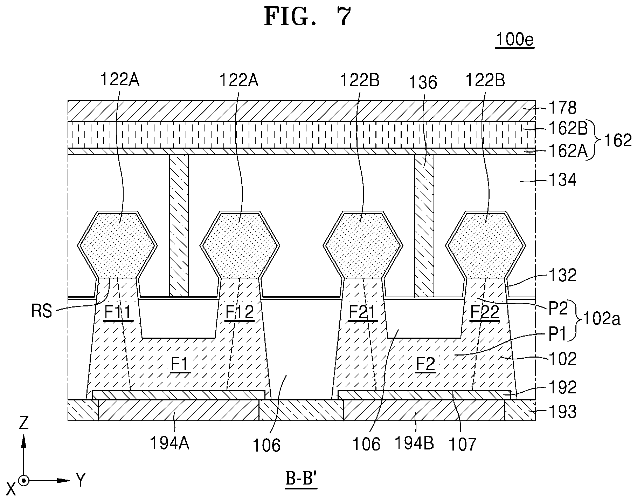

FIG. 7 is a cross-sectional view of an integrated circuit device 100e according to an embodiment of the present inventive concept, corresponding to the cross-sectional view taken along line B-B' of FIG. 1. A difference between embodiments of FIG. 7 and FIG. 6 is whether the plurality of fin-type active areas F1 and F2 include the semiconductor substrate 102 and the active substrate 102a. In this specification, it may be understood that the semiconductor substrate 102 is made of a semiconductor not doped with impurities, and the active substrate 102a is made of a semiconductor doped with impurities.

According to an embodiment, the active substrate 102a may be disposed to surround side and lower surfaces of the device isolation film 106 disposed inside the plurality of fin-type active areas F1 and F2. For example, the active substrate 102a may include a first portion P1 surrounding the lower surface of the device isolation film 106 disposed inside the plurality of fin-type active areas F1 and F2, and a second portion P2 surrounding the side surface of the device isolation film 106.

For example, in the first fin-type active area F1, the active substrate 102a may surround side and lower surfaces of the device isolation film 106 between the third fin-type active area F11 and the fourth fin-type active area F12, and in the second fin-type active area F2, the active substrate 102a may surround side and lower surfaces of the device isolation film 106 between the fifth fin-type active area F21 and the sixth fin-type active area F22.

According to an embodiment, the first portion P1 may connect individual fin-type active areas F11, F12, F21, and F22 constituting the plurality of fin-type active areas F1 and F2 to each other. For example, the third fin-type active area F11 and the fourth fin-type active area F12 of the first fin-type active area F1 may be connected to each other through the first portion P1 of the active substrate 102a, and the fifth fin-type active area F21 and the sixth fin-type active area F22 of the second fin-type active area F2 may be connected to each other through the first portion P1 of the active substrate 102a. According to an embodiment, the second portion P2 may extend from the first portion P1 of the active substrate 102a and be connected to the first and second source/drain areas 122 and 124.

According to an embodiment, the semiconductor substrate 102 may be disposed to surround a side surface of the active substrate 102a. For example, the semiconductor substrate 102 may not surround the lower surface 107 of the active substrate 102a, and the active substrate 102a may face the upper surface of the back side interconnection structure 194 with the second metal silicide film 192 covering the lower surface 107 therebetween.

According to an embodiment, the lower surface 107 of the active substrate 102a may entirely overlap the back surface conductive wiring structure 194 in the Z direction. According to an embodiment, the second metal silicide film 192 may entirely cover the back side interconnection structure 194 on the lower surface 107 of the active substrate 102a and may be between the active substrate 102a and the back side interconnection structure 194 (e.g., in the Z direction).

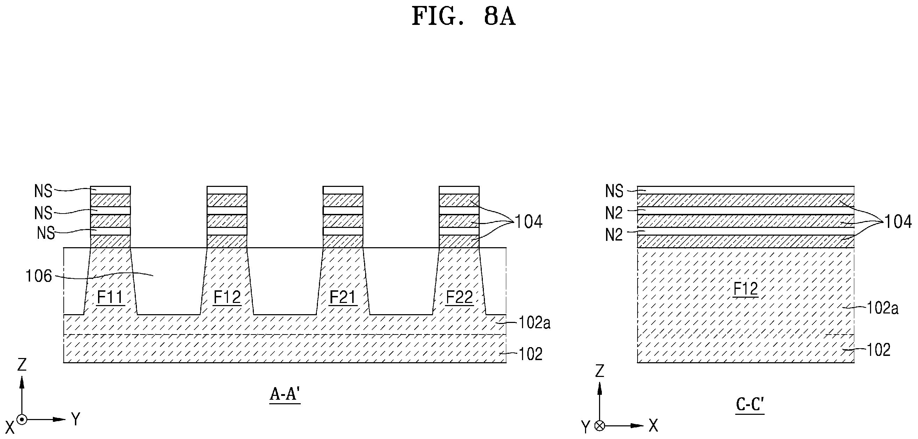

FIGS. 8A to 8J are cross-sectional views of an unclaimed process sequence to explain a method of manufacturing an integrated circuit device 100 according to embodiments of the present inventive concept, and show cross-sections along lines A-A' and C-C' in FIG. 1.

Referring to FIG. 8A, after the active substrate 102a is formed on the semiconductor substrate 102, and the plurality of sacrificial semiconductor layers 104 and the plurality of nanosheet semiconductor layers NS are alternately stacked one-by-one on the active substrate 102a (e.g., in the Z direction), in the PMOS transistor area PA and the NMOS transistor area NA, a portion of each of the plurality of sacrificial semiconductor layers 104, the plurality of nanosheet semiconductor layers NS, and the active substrate 102a is etched to form a plurality of fin-type active areas F1 and F2 that protrude upward from the active substrate 102a in the Z direction and extend in parallel to each other in the X direction and to form a device isolation film 106 covering both sidewalls of each of the plurality of fin-type active areas F1 and F2. An upper surface level of the device isolation film 106 may be the same as or similar to an upper surface FT level of each of the fin-type active areas of the plurality of fin-type active areas F1 and F2.

In the PMOS transistor area PA and the NMOS transistor area NA, a stacked structure of a plurality of sacrificial semiconductor layers 104 and a plurality of nanosheet semiconductor layers NS may remain on the fin upper surface FT of each of the plurality of fin-type active areas F1 and F2.

The plurality of sacrificial semiconductor layers 104 and the plurality of nanosheet semiconductor layers NS may be formed of semiconductor materials having different etch selectivities from each other. The plurality of nanosheet semiconductor layers NS may be formed of Si layers, and the plurality of sacrificial semiconductor layers 104 may be formed of SiGe layers. The Ge content in the plurality of sacrificial semiconductor layers 104 may be constant. For example, the SiGe layer constituting the plurality of sacrificial semiconductor layers 104 may have a constant Ge content selected within a range of about 5 atomic % to about 60 atomic %, for example, about 10 atomic % to about 40 atomic %. For example, the Ge content in the SiGe layer constituting the plurality of sacrificial semiconductor layers 104 may be variously selected as necessary.

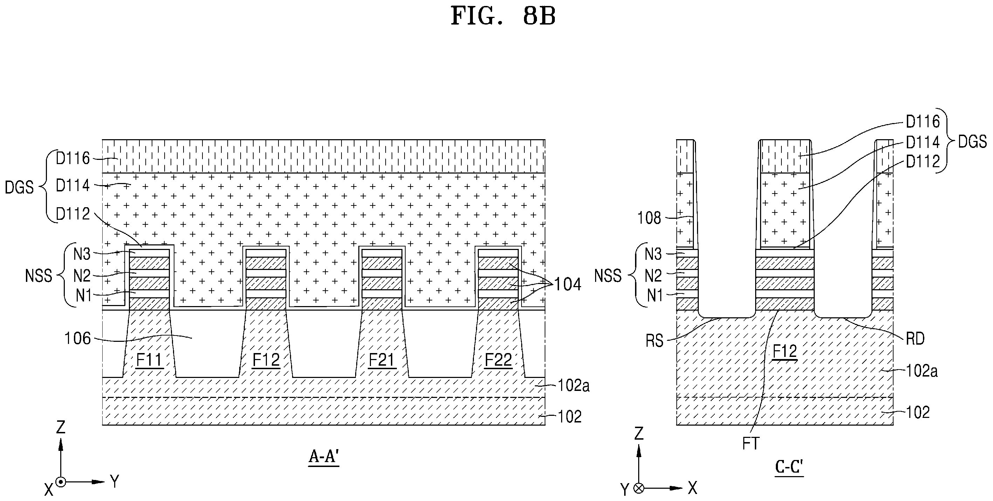

Referring to FIGS. 8A and 8B together, in the PMOS transistor area PA, a plurality of dummy gate structures DGS and an outer insulating spacer 108 covering both sidewalls of each of the plurality of dummy gate structures DGS may be formed on the laminated structure of the plurality of sacrificial semiconductor layers 104 and the plurality of nanosheet semiconductor layers NS. The plurality of dummy gate structures DGS may be formed to extend continuously in the Y direction at positions corresponding to the plurality of gate structures 140 illustrated in FIG. 1.

Each of the plurality of dummy gate structures DGS may have a structure in which a dummy oxide film D112, a dummy gate layer D114, and a capping layer D116 are sequentially stacked (e.g., in the Z direction). The dummy gate layer D114 may be formed of a polysilicon film, and the capping layer D116 may be formed of a silicon nitride film.

The NMOS transistor area NA may then be covered with a mask, and the dummy gate structure DGS and the outer insulating spacer 108 are used as an etch mask in the PMOS transistor area PA to remove a portion of each of the plurality of sacrificial semiconductor layers 104 and the plurality of nanosheet semiconductor layers NS, so that a plurality of nanosheet stacks NSS may be formed from the plurality of nanosheet semiconductor layers NS. Each of the plurality of nanosheet stacks NSS may include first to third nanosheets N1, N2, and N3. A portion of the first fin-type active area F1 exposed between each of the plurality of nanosheet stacks NSS in the PMOS transistor area PA is etched, so that a plurality of first and second recesses RS and RD may be formed above the first fin-type active area F1. To form the plurality of first and second recesses RS and RD, the first fin-type active area F1 may be etched using a dry method, a wet method, or a combination thereof.

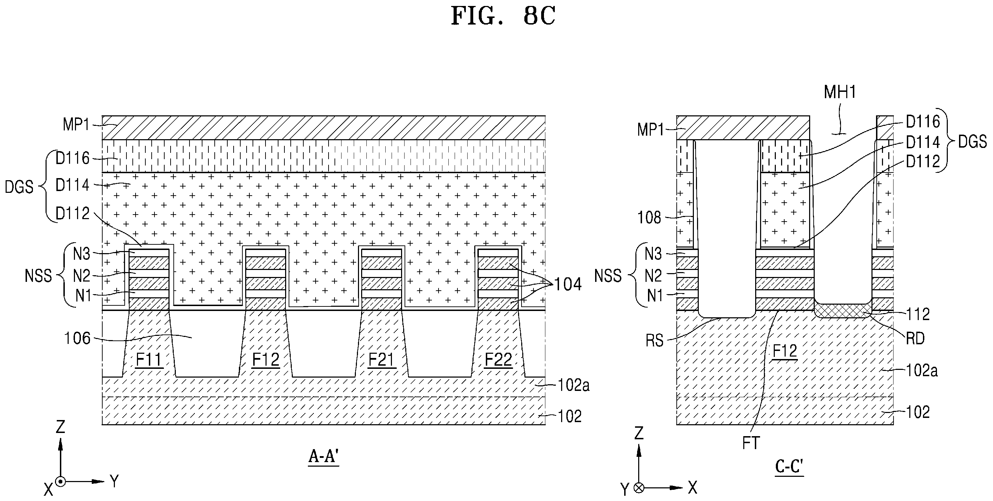

Referring to FIG. 8C, a first mask pattern MP1 may be disposed to cover the first recess RS, and the second recess RD may be exposed through the first mask hole MH1. After that, a first source/drain insulating structure 112 partially filling the second recess RD may be formed. The first source/drain insulating structure 112 may be formed through an atomic layer deposition (ALD) process, a chemical vapor deposition (CVD) process, a physical vapor deposition (PVD) process, a plasma enhanced CVD (PECVD) process, a low pressure CVD (LPCVD) process, or the like.

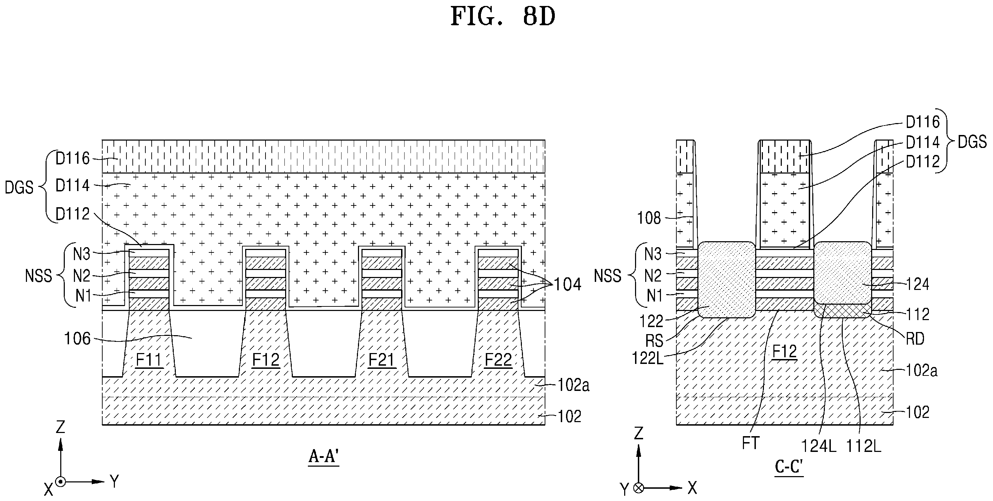

Referring to FIG. 8D, a second source/drain area 124 may be formed on the first source/drain insulating structure 112. The second source/drain area 124 may be formed from the nanosheet stack NSS on both sides of the second recess RD. To form the second source/drain area 124, a semiconductor material may be epitaxially grown from sidewalls of each of the first to third nanosheets N1, N2, and N3.

Thereafter, after the first mask pattern is removed and a mask pattern covering the second recess RD and exposing the first recess RS is disposed, a first source/drain area 122 may be formed in the first recess RS. To form the first source/drain area 122, a semiconductor material may be epitaxially grown from the surface of the first fin-type active area F1 exposed through the bottom surface of the first recess RS and the sidewalls of each of the first to third nanosheets N1, N2, and N3.

To form the first and second source/drain areas 122 and 124, an LPCVD process, a selective epitaxial growth (SEG) process, or a cyclic deposition and etching (CDE) process may be performed using raw materials including an element semiconductor precursor. The first and second source/drain areas 122 and 124 may be formed of a SiGe layer doped with a p-type dopant. Silane (SiH₄), disilane (Si₂H₆), trisilane (Si₃H₈), dichlorosilane (SiH₂Cl₂), or the like may be used as the Si source to form the first and second sources/drain areas 122 and 124. The p-type dopant may be selected from boron (B) and gallium (Ga). However, it is not necessarily limited thereto.

Thereafter, a process of covering the PMOS transistor area PA with a mask and forming a plurality of source/drain areas 122 and 124 with respect to the NMOS transistor area NA may be performed in the same manner. The plurality of source/drain areas 122 and 124 of the NMOS transistor area NA may be formed of a Si layer doped with an n-type dopant or a SiC layer doped with an n-type dopant. A Si source and a Ge source may be used to form the plurality of sources/drain areas 122 and 124. As the Si source, silane (SiH₄), disilane (Si₂H₆), trisilane (Si₃H₈), dichlorosilane (SiH₂Cl₂), or the like may be used. As the Ge source, Germane (GeH₄), Digermane (Ge₂H₆), Trigermane (Ge₃H₈), tetragermane (Ge₄H₁₀), dichloro germane (Ge₂H₂Cl₂), and the like may be used. The n-type dopant may be selected from phosphorus (P), arsenic (As), and antimony (Sb). However, it is not necessarily limited thereto.

After that, in the PMOS transistor area PA and the NMOS transistor area NA, an insulating liner 132 covering surfaces of each of the plurality of first and second source/drain areas 122 and 124 and each surface of the plurality of outer insulating spacers 108 may be formed, and an inter-gate insulating film 134 may be formed on the insulating liner 132. Thereafter, the upper surface of the dummy gate layer D114 may be exposed by removing the capping layer D 116 and planarizing the plurality of outer insulating spacers 108, the insulating liner 132, and the inter-gate insulating film 134.

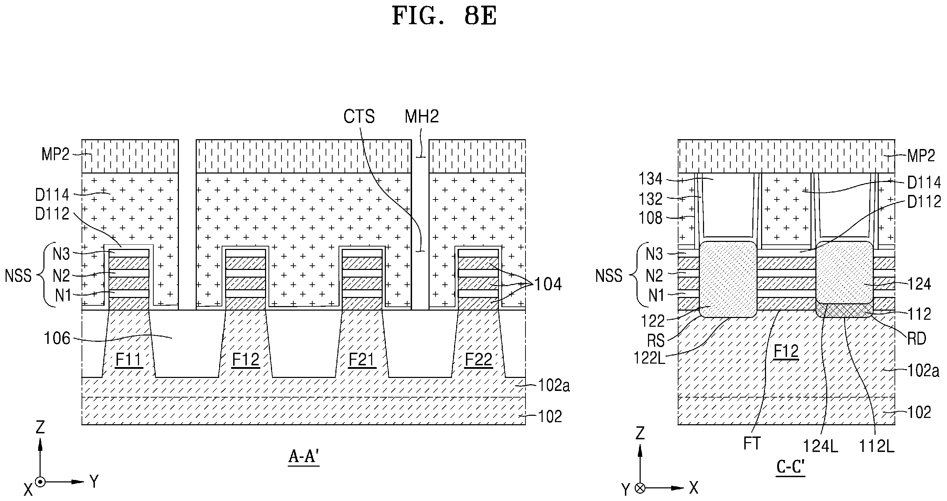

Referring to FIG. 8E, a second mask pattern MP2 may be formed to cover the dummy gate layer D114, the insulating liner 132, and the inter-gate insulating film 134. The second mask pattern MP2 may have a plurality of second openings MH2 that expose a portion of the dummy gate layer D114 and a portion of each of the outer insulating spacer 108, the insulating liner 132, and the inter-gate insulating film 134 around the portion of the dummy gate layer D114. Positions of each of the plurality of second openings MH2 formed in the second mask pattern MP2 may correspond to positions of the plurality of gate cut insulating patterns 136 illustrated in FIG. 1.

A partial area of the dummy gate layer D114 exposed through the plurality of second openings MH2 formed in the second mask pattern MP2 is selectively anisotropically etched, and as a result of partial areas of the dummy gate layer D114 being etched, the oxide film D112 exposed through the plurality of second openings MH2 is etched, so that the device isolation film 106 may be exposed through the plurality of second openings MH2. As a result, a plurality of gate cut spaces CTS communicating with the plurality of second openings MH2 may be formed in the dummy gate layer D114.

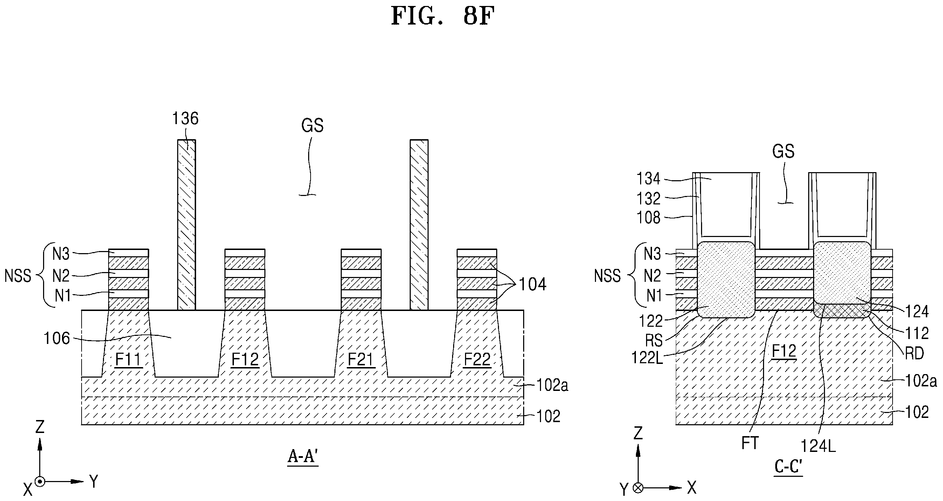

Referring to FIG. 8F , after the third mask pattern MP3 is removed from the result of FIG. 8E, a plurality of gate cut insulating patterns 136 filling the plurality of gate cut spaces CTS may be formed.

Thereafter, a plurality of gate spaces GS may be formed on the nanosheet stack NSS by removing the dummy gate layer D114 and the oxide film D112 thereunder. Each of the plurality of gate spaces GS may be limited in length in the Y direction by the plurality of gate cut insulating patterns 136.

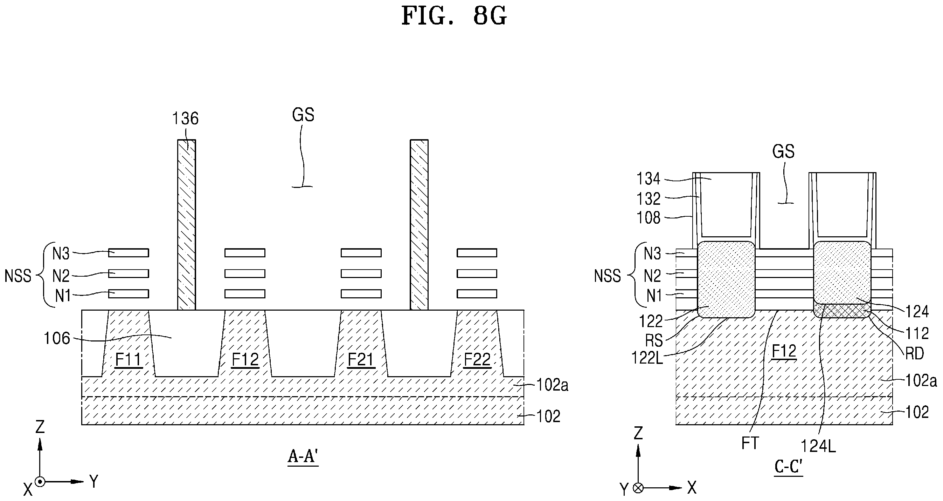

Referring to FIG. 8G, the plurality of sacrificial semiconductor layers 104 remaining on the plurality of fin-type active areas F1 and F2 are removed through the gate space GS on the top of the nanosheet stack NSS, so that the gate space GS may extend to a space between each of the plurality of nanosheets N1, N2, and N3 and a space between the first nanosheet N1 and the fin upper surface FT.

To selectively remove the plurality of sacrificial semiconductor layers 104, a difference in etch selectivity between the plurality of nanosheets N1, N2, and N3 and the plurality of sacrificial semiconductor layers 104 may be used. A liquid or gaseous etchant may be used to selectively remove the plurality of sacrificial semiconductor layers 104. To selectively remove the plurality of sacrificial semiconductor layers 104, a CH₃COOH-based etchant, for example, an etchant composed of a mixture of CH₃COOH, HNO₃, and HF, or an etchant composed of a mixture of CH₃COOH, H₂O₂, and HF may be used. However, it is not necessarily to those exemplified above.

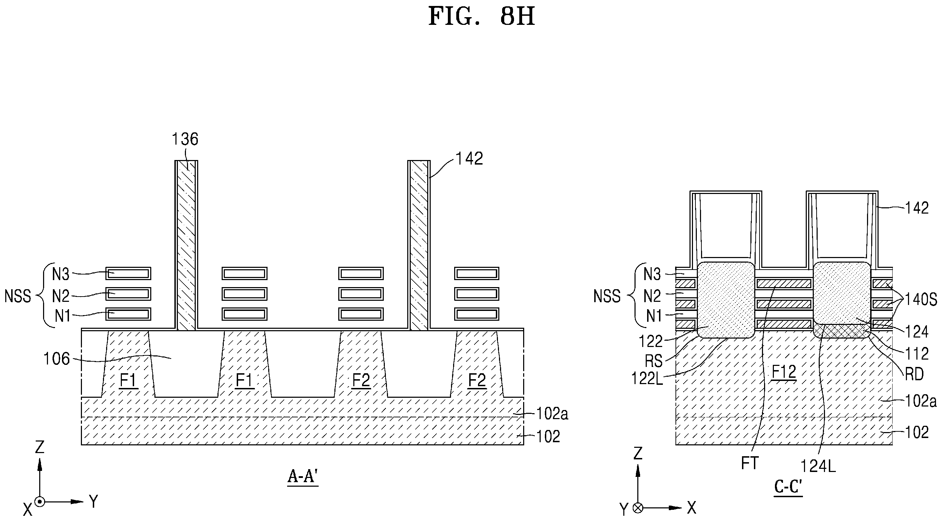

Referring to FIG. 8H, in the result of FIG. 8G, a gate dielectric film 142 covering exposed surfaces of the plurality of nanosheets N1, N2, and N3 and the plurality of fin-type active areas F1 and F2 may be formed. The gate dielectric film 142 may be formed to conformally cover surfaces of the plurality of outer insulating spacers 108 and surfaces of the plurality of gate cut insulating patterns 136 exposed through the gate space GS.

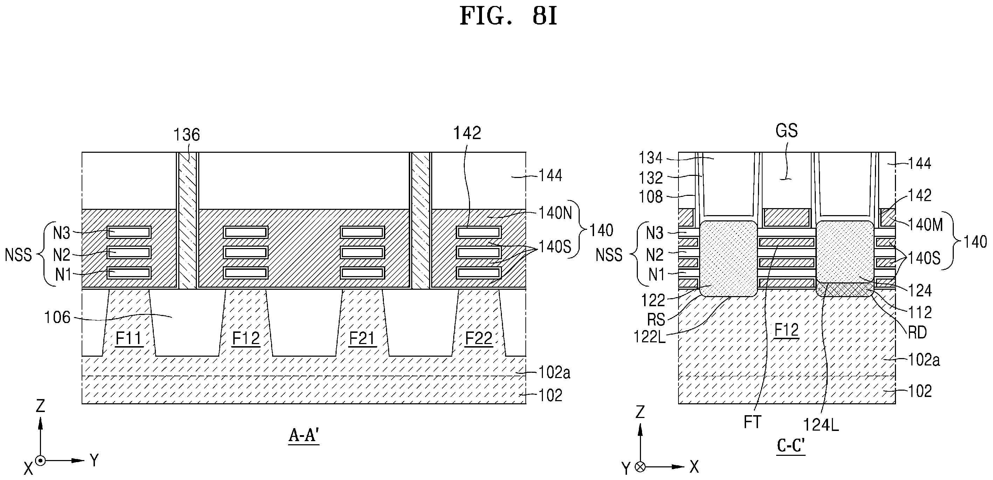

Referring to FIG. 8I, a plurality of gate structures 140 filling the gate space GS may be formed. For example, a plurality of sub gate portions 140S may be formed between the plurality of nanosheets N1, N2, and N3 and between the first nanosheet N1 and the upper surfaces FT of the plurality of fin-type active areas F1 and F2, and a main gate portion 140M may be formed on the third nanosheet N3. The plurality of gate structures 140 may face the plurality of nanosheets N1, N2, and N3 and the upper surfaces FT of the plurality of fin-type active areas F1 and F2 with the gate dielectric film 142 therebetween. After that, a capping insulating pattern 144 covering upper surfaces of the plurality of gate structures 140 may be formed.

Both sidewalls of the main gate portion 140M may face the outer insulating spacer 108 with the gate dielectric film 142 therebetween (e.g., in the X direction). Both sidewalls of the plurality of sub gate portions 140S may face the plurality of first and second source/drain areas 122 and 124 with the gate dielectric film 142 therebetween (e.g., in the X direction). A width of the main gate portion 140M in the X direction may be less than a width of the sub gate portion 140S in the X direction.

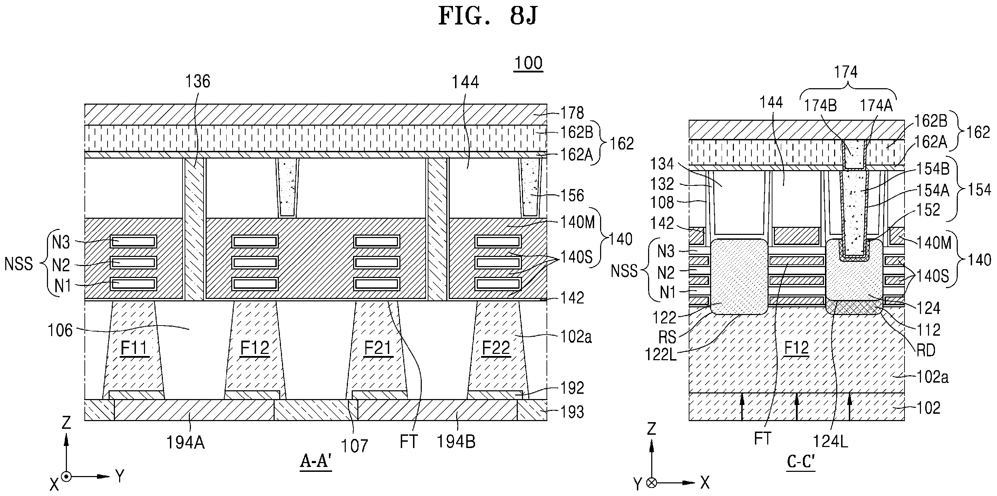

Referring to FIG. 8J, in the result of FIG. 8I, after disposing a mask pattern partially exposing the inter-gate insulating film 134 on the second source/drain area 124, a first metal silicide film 152 and a first contact structure 154 may be formed. For example, the gate contact 156 may be formed together in this operation. After that, after removing the mask pattern through a planarization process, an upper insulating structure 162 may be formed by sequentially stacking an etch stop film 162A and an interlayer insulating film 162B on the planarized first contact structure 154 (e.g., in the Z direction). Thereafter, after disposing a mask pattern partially exposing the upper insulating structure 162 on the first contact structure 154 and the gate contact 156, the via structure 174 may be formed. After that, a front side interconnection structure 178 connected to the via structure 174 may be formed.

After forming the front side interconnection structure 178, the semiconductor substrate 102 may be removed through a chemical mechanical polishing or planarization (CMP) process. Accordingly, the entire semiconductor substrate 102 under the active substrate 102a may be removed, and only the active substrate 102a may remain, and the lower surface 107 of the active substrate 102a may be exposed.

Referring to FIGS. 8J, 2A, and 2C together, a first lower insulating structure 193 may be formed on the exposed lower surface 107 of the active substrate 102a. For example, the first lower insulating structure 193 may be formed through an ALD process, a CVD process, a PVD process, a PECVD process, a LPCVD process, or the like. Thereafter, the first lower insulating structure 193 may be partially etched to form a back side interconnection structure 194 in the recessed space. In this operation, portions of the active substrate 102a of the plurality of fin-type active areas F1 and F2 may be partially removed or replaced to form the second metal silicide film 192.

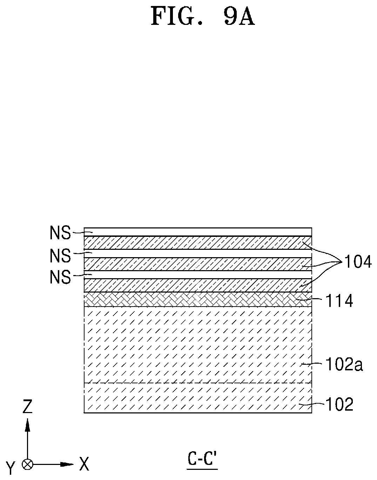

FIGS. 9A to 9C are cross-sectional views of an unclaimed process sequence to explain a method of manufacturing the integrated circuit device 100b shown in FIG. 4 according to embodiments of the present inventive concept, and show a cross-section corresponding to the cross-section taken along the line C-C' in FIG. 1.

Referring to FIG. 9A, a second source/drain insulating structure 114 may be formed on the active substrate 102a, and a plurality of sacrificial semiconductor layers 104 and a plurality of nanosheet semiconductor layers NS may be alternately stacked one-by-one on the second source/drain insulating structure 114 (e.g., in the Z direction). Between the active substrate 102a and the sacrificial semiconductor layer 104 disposed at the lowest level in the Z direction among the plurality of sacrificial semiconductor layers 104, a process similar to that described with reference to FIG. 8A may be performed except that the second source/drain insulating structure 114 is formed.

Before the plurality of sacrificial semiconductor layers 104 and the plurality of nanosheet semiconductor layers NS are formed, the second source/drain insulating structure 114 may be formed by stacking a separate insulating material layer on the active substrate 102a. As described above with reference to FIG. 8A, after stacking a plurality of sacrificial semiconductor layers 104 and a plurality of nanosheet semiconductor layers NS on the active substrate 102a, the second source/drain insulating structure 114 may be formed by replacing an upper portion of the active substrate 102a with an insulating material. For example, the second source/drain insulating structure 114 may be replaced with a bottom dielectric insulation film or an upper portion of the active substrate 102a may be replaced.

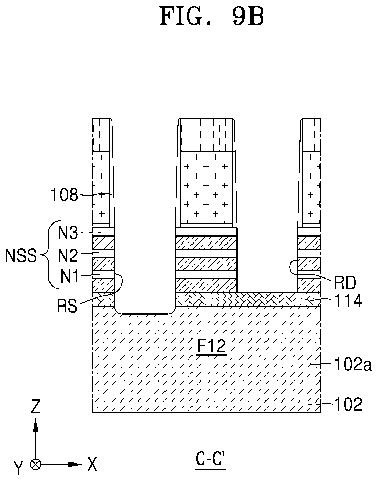

Referring to FIG. 9B, similar to the above with reference to FIG. 8B, after forming a plurality of dummy gate structures DGS on the stacked structure of the plurality of sacrificial semiconductor layers 104 and the plurality of nanosheet semiconductor layers NS and an outer insulating spacer 108 covering both sidewalls of each of the plurality of dummy gate structures DGS, a first recess RS and a second recess RD may be formed. The first recess RS may penetrate the second source/drain insulating structure 114, and the second recess RD may not penetrate the second source/drain insulating structure 114. For example, after disposing a mask pattern on the plurality of dummy gate structures DGS to cover the portion where the first recess RS is formed and expose the portion where the second recess RD is formed to form the second recess RD, in the same manner, the first recess RS may be formed by disposing another mask pattern that covers the portion where the second recess RD is formed and exposes the portion where the first recess RS is formed. Thereafter, the first source/drain area 122 may be formed in the first recess RS, and the second source/drain area 124 may be formed in the second recess RD.

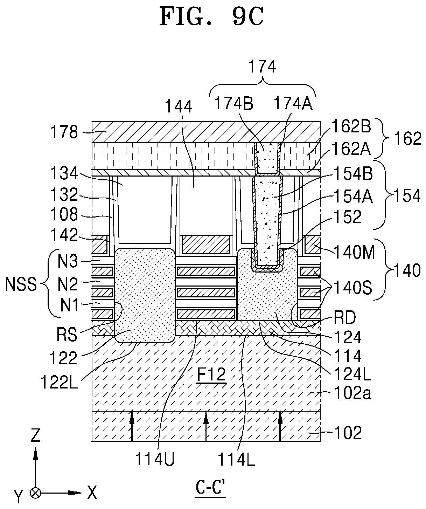

Referring to FIG. 9C, similarly as described with reference to FIGS. 8F to 8J, after forming the gate structure 140, the first contact structure 154, the via structure 174, and the front side interconnection structure 178, the lower surface 107 of the active substrate 102a may be exposed by removing the semiconductor substrate 102 through a planarization process.

Referring to FIGS. 9C and 4 together, a first lower insulating structure 193 may be formed on the exposed lower surface 107 of the active substrate 102a. For example, the first lower insulating structure 193 may be formed through an ALD process, a CVD process, a PVD process, a PECVD process, a LPCVD process, or the like. Thereafter, the first lower insulating structure 193 may be partially etched to form a back side interconnection structure 194 in the recessed space. In this operation, portions of the active substrate 102a of the plurality of fin-type active areas F1 and F2 may be partially removed or replaced to form the second metal silicide film 192.

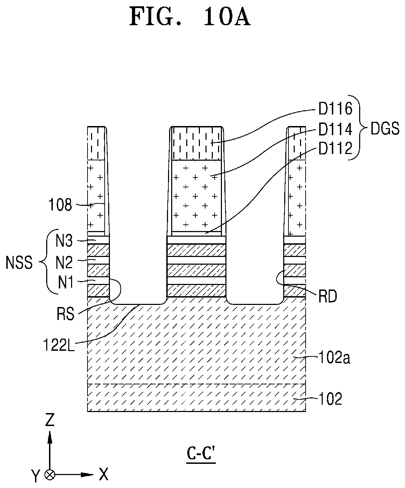

FIGS. 10A to 10C are cross-sectional views taken along the line C-C' of FIG. 1 to explain an unclaimed manufacturing method of the integrated circuit device 100c shown in FIG. 5 according to embodiments and show a cross-section corresponding to the cross-section taken along the line C-C' of FIG. 1.

Referring to FIG. 10A, similar to that described with reference to FIGS. 8A and 8B, a second source/drain insulating structure 114 may be formed on the active substrate 102a, and a plurality of sacrificial semiconductor layers 104 and a plurality of nanosheet semiconductor layers NS may be alternately stacked one-by-one on the second source/drain insulating structure 114 (e.g., in the Z direction). After that, first and second recesses RS and RD may be formed passing through the plurality of sacrificial semiconductor layers 104 and the plurality of nanosheet semiconductor layers NS.

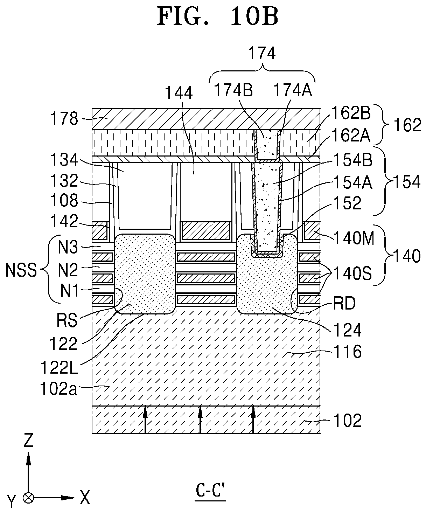

Referring to FIG. 10B, a first source/drain area 122 may be disposed in the first recess RS, and a second source/drain area 124 may be disposed in the second recess RD. In this operation, the first source/drain area 122 and the second source/drain area 124 may each contact the active substrate 102a. Thereafter, similarly as described with reference to FIGS. 8F to 8J, after forming the gate structure 140, the first contact structure 154, the via structure 174, and the front side interconnection structure 178, the lower surface 107 of the active substrate 102a may be exposed by removing the semiconductor substrate 102 through a planarization process.

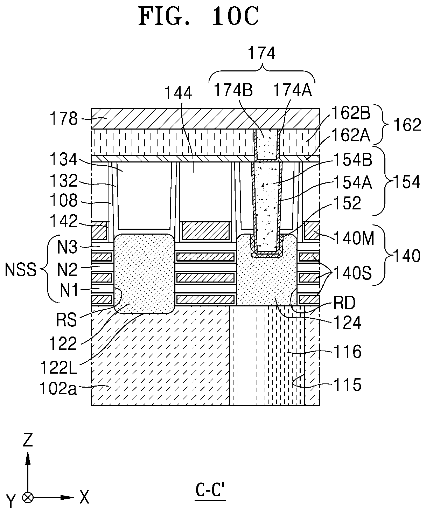

Referring to FIG. 10C, after disposing a mask pattern exposing a portion of the active substrate 102a overlapping the second source/drain area 124 in the Z direction on the lower surface 107 of the active substrate 102a, an open hole 115 penetrating the active substrate 102a and exposing the second source/drain area 124 may be formed through an etching process or the like. The width of the open hole 115 in a horizontal direction (e.g., the X direction and/or the Y direction) may be greater than that of the second source/drain area 124 in a horizontal direction (e.g., the X direction and/or the Y direction). For example, the open hole 115 may be a space defined by the active substrate 102a, the gate dielectric film 142, and the second source/drain area 124. Thereafter, a third source/drain insulating structure 116 filling the open hole 115 may be formed.

Referring to FIGS. 10C and 5 together, a first lower insulating structure 193 may be formed on the exposed lower surface 107 of the active substrate 102a and the third source/drain insulating structure 116. For example, the first lower insulating structure 193 may be formed through an ALD process, a CVD process, a PVD process, a PECVD process, a LPCVD process, or the like. Thereafter, the first lower insulating structure 193 may be partially etched to form a back side interconnection structure 194 in the recessed space. In this operation, portions of the active substrate 102a of the plurality of fin-type active areas F1 and F2 may be partially removed or replaced to form the second metal silicide film 192.

Various embodiments described herein include features that are described as relating to a "back side" or "front side" of the semiconductor device. It will be appreciated that these features relate to opposite sides of the semiconductor device. Having said this, these features do not imply any particularly orientation of the device in use. Furthermore, certain features are described as being "above" (or "higher" than) other features, which may be described as being "below" (or "lower"). Higher features may be features that are further along a vertical direction (e.g. the Z direction) and may be closer to the front side (or further from the back side) than lower features (e.g. along a direction from the back side towards the front side). Similarly "upper" features may be higher than "lower" features. For instance, an upper surface of a component may be the highest surface of that component, and a lower surface may be the lowest surface of that component. These terms should be construed as being relative to other features of the semiconductor device, and should not imply any particular orientation of the device in use.

While the present inventive concept has been particularly shown and described with reference to embodiments thereof, it will be understood that various changes in form and details may be made therein without departing from the scope of the present invention as defined in the appended claims.

## Claims

1. An integrated circuit device (100) comprising:
a back side interconnection structure (194) extending in a first horizontal (X) direction;
an active substrate (102a) including a plurality of fin-type active areas (F1, F2) extending in the first horizontal (X) direction on the back side interconnection structure (194), the active substrate (102a) comprising a semiconductor substrate doped with impurities;
a metal silicide film (192) between the back side interconnection structure (194) and the active substrate (102a);
a plurality of gate structures (140) disposed on the plurality of fin-type active areas (F1, F2) and extending in a second horizontal (Y) direction perpendicular to the first horizontal (X) direction on the active substrate (102a); and
a first source/drain area (122) and a second source/drain area (124) spaced apart from each other in the first horizontal (X) direction with a gate structure (140) therebetween on the active substrate (102a); and
wherein the first source/drain area (122) directly contacts the active substrate (102a) such that the back side interconnection structure (194) is electrically connected to the first source/drain area (122) through the metal silicide film (192) and the active substrate (102a);
the integrated circuit device (100) further comprising a plurality of nanosheet stacks (NSS) disposed on the fin-type active areas (F1, F2) and surrounded by the plurality of gate structures (140),
wherein the first source/drain area (122) is disposed in a first recess (RS) defined in the active substrate (102a) between the plurality of nanosheet stacks (NSS), and the second source/drain area (124) is disposed in a second recess (RD) defined in the active substrate (102a) between the plurality of nanosheet stacks (NSS), and
wherein the second source/drain area (124) is spaced apart from the active substrate (102a) and insulated from the active substrate (102a) by a source/drain insulating structure (112) that is disposed under the second source/drain area (124) and above the active substrate (102a).

2. The integrated circuit device (100) of claim 1, wherein a lower surface (124L) of the second source/drain area (124) is located at a higher level than an upper surface (FT) of the fin-type active area (F1, F2) in a vertical (Z) direction.

3. The integrated circuit device (100) of any preceding claim, wherein:
the source/drain insulating structure (114) extends in the first horizontal (X) direction on the fin-type active area (F1, F2),
wherein the first source/drain area (122) passes through the source/drain insulating structure (114) and directly contacts the active substrate (102a), and
wherein the second source/drain area (124) is spaced apart from the active substrate (102a) with the source/drain insulating structure (114) therebetween.

4. An integrated circuit device (100), comprising:
a back side interconnection structure (194) extending in a first horizontal (X) direction;
an active substrate (102a) including a plurality of fin-type active areas (F1, F2) extending in the first horizontal (X) direction on the back side interconnection structure (194), the active substrate (102a) comprising a semiconductor substrate doped with impurities;
a metal silicide film (192) between the back side interconnection structure (194) and the active substrate (102a);
a plurality of gate structures (140) disposed on the plurality of fin-type active areas (F1, F2) and extending in a second horizontal (Y) direction perpendicular to the first horizontal (X) direction on the active substrate (102a); and
a first source/drain area (122) and a second source/drain area (124) spaced apart from each other in the first horizontal (X) direction with a gate structure (140) therebetween on the active substrate (102a);
wherein the first source/drain area (122) directly contacts the active substrate (102a) such that the back side interconnection structure (194) is electrically connected to the first source/drain area (122) through the metal silicide film (192) and the active substrate (102a); and
the integrated circuit device (100) further comprising a plurality of nanosheet stacks (NSS) disposed on the fin-type active areas (F1, F2) and surrounded by the plurality of gate structures (140),
wherein the first source/drain area (122) is disposed in a first recess (RS) defined in the active substrate (102a) between the plurality of nanosheet stacks (NSS), and the second source/drain area (124) is disposed in a second recess (RD) defined in the active substrate (102a) between the plurality of nanosheet stacks (NSS), and
wherein the second source/drain area (124) is spaced apart from the active substrate (102a) by a source/drain insulating structure (116) disposed on a lower surface (124L) of the second source/drain area (124), wherein said source/drain insulating structure (116) overlaps the second source/drain area (124) in a vertical (Z) direction and penetrates the active substrate (102a) in the vertical (Z) direction.

5. The integrated circuit device of claim 4, wherein a width (W1) of the source/drain insulating structure (116) in the first horizontal (X) direction and/or the second horizontal (Y) direction is greater than a width (W2) of the second source/drain area (124) in the first horizontal (X) direction and/or the second horizontal (Y) direction.

6. The integrated circuit device (100) of claim 4 or 5, wherein the lower surface (124L) of the second source/drain area (124) is located at a higher level than an upper surface (FT) of the fin-type active area (F1, F2) in a vertical (Z) direction.

7. The integrated circuit device (100) of any preceding claim, wherein:
the active substrate (102a) comprises a P-channel metal oxide semiconductor, PMOS, transistor area and an N-channel metal oxide semiconductor, NMOS, transistor area,
wherein the fin-type active area (F1, F2) comprises a first fin-type active area (F1) of the PMOS transistor area and a second fin-type active area (F2) of the NMOS transistor area,
wherein the first fin-type (F1) active area comprises a third fin-type (F11) active area and a fourth fin-type active area (F12) spaced apart from each other in the second horizontal (Y) direction and extending parallel to each other in the first horizontal (X) direction, and the second fin-type active area (F2) comprises a fifth fin-type active area (F21) and a sixth fin-type active area (F22) spaced apart from each other in the second horizontal (Y) direction and extending parallel to each other in the first horizontal (X) direction, and
wherein the third fin-type active area (F11), the fourth fin-type active area (F12), the fifth fin-type active area (F21), and the sixth fin-type active area (F22) are independent active substrates, respectively, and are spaced apart from each other with a device isolation film (106) therebetween.

8. The integrated circuit device (100) of any of claims 1-6, wherein:
the active substrate (102a) comprises a PMOS transistor area (PA) and an NMOS transistor area (NA),
wherein the fin-type active area (F1, F2) comprises a first fin-type active (F1) area of the PMOS transistor area (PA) and a second fin-type active area (F2) of the NMOS transistor area (NA),
wherein the first fin-type active area (F1) comprises a third fin-type active area (F11) and a fourth fin-type active (F12) area spaced apart from each other in the second horizontal (Y) direction and extending parallel to each other in the first horizontal (X) direction,
wherein the second fin-type active area (F2) comprises a fifth fin-type active area (F21) and a sixth fin-type active area (F22) spaced apart in the second horizontal (Y) direction and extending parallel to each other in the first horizontal (X) direction,
wherein the first fin-type active area (F1) has an integral structure in which the third fin-type active area (F11) and the fourth fin-type active area (F12) are connected,
wherein the second fin-type active area (F2) has an integral structure in which the fifth fin-type active area (F21) and the sixth fin-type active area (F22) are connected, and
wherein the first fin-type active area (F1) and the second fin-type active area (F2) are spaced apart from each other with a device isolation film (106) therebetween.

9. The integrated circuit device (100) of claim 8, wherein the metal silicide film (192) entirely covers a lower surface of the first fin-type active area (F1) and a lower surface of the second fin-type active area (F2) on the back side interconnection structure (194).

10. The integrated circuit device (100) of any preceding claim, wherein the metal silicide film extends in the first horizontal (X) direction on the back side interconnection structure (194) and overlaps the second source/drain area in a vertical (Z) direction.

11. The integrated circuit device (100) of any preceding claim, further comprising an upper contact structure (154) in direct contact with the second source/drain area (124) on the second source/drain area (124).

12. The integrated circuit device (100) of any of claims 1 to 6, comprising:
a lower insulating structure (181) on the back side interconnection structure (194); and
a lower contact structure (184) penetrating the lower insulating structure (181) and electrically connecting the active substrate (102a) to the back side interconnection structure (194);
wherein the metal silicide film (182) is disposed between the active substrate (102a) and the lower contact structure (184)..

13. The integrated circuit device (100) of claim 12, wherein the lower contact structure (184) overlaps the first source/drain area (122) in a vertical (Z) direction.

14. The integrated circuit device (100) of claim 12 or claim 13, further comprising an upper contact structure (154) disposed on the second source/drain area (124), and directly contacting the second source/drain area (124).

## Patentansprüche

1. Integrierte Schaltungsvorrichtung (100), umfassend:
eine rückseitige Verbindungsstruktur (194), die sich in einer ersten horizontalen (X-) Richtung erstreckt;
ein aktives Substrat (102a), das eine Vielzahl von rippenartigen aktiven Bereichen (F1, F2) beinhaltet, die sich in der ersten horizontalen (X-) Richtung auf der rückseitigen Verbindungsstruktur (194) erstrecken, wobei das aktive Substrat (102a) ein mit Verunreinigungen dotiertes Halbleitersubstrat umfasst;
einen Metallsilizidfilm (192) zwischen der rückseitigen Verbindungsstruktur (194) und dem aktiven Substrat (102a);
eine Vielzahl von Gatter-Strukturen (140), die auf der Vielzahl von rippenartigen aktiven Bereichen (F1, F2) angeordnet sind und sich in einer zweiten horizontalen (Y-) Richtung senkrecht zur ersten horizontalen (X-) Richtung auf dem aktiven Substrat (102a) erstrecken; und
einen ersten Quellen-/Senken-Bereich (122) und einen zweiten Quellen-/Senken-Bereich (124), die in der ersten horizontalen (X-) Richtung voneinander beabstandet sind, mit einer Gatter-Struktur (140) dazwischen auf dem aktiven Substrat (102a); und
wobei der erste Quellen-/Senken-Bereich (122) das aktive Substrat (102a) direkt kontaktiert, sodass die rückseitige Verbindungsstruktur (194) durch den Metallsilizidfilm (192) und das aktive Substrat (102a) elektrisch mit dem ersten Quellen-/Senken-Bereich (122) verbunden ist;
wobei die integrierte Schaltungsvorrichtung (100) weiter eine Vielzahl von Nanoblattstapeln (NSS) umfasst, die auf den rippenartigen aktiven Bereichen (F1, F2) angeordnet und von der Vielzahl von Gatter-Strukturen (140) umgeben sind,
wobei der erste Quellen-/Senken-Bereich (122) in einer ersten Aussparung (RS) angeordnet ist, die im aktiven Substrat (102a) zwischen der Vielzahl von Nanoblattstapeln (NSS) definiert ist, und der zweite Quellen-/Senken-Bereich (124) in einer zweiten Aussparung (RD) angeordnet ist, die im aktiven Substrat (102a) zwischen der Vielzahl von Nanoblattstapeln (NSS) definiert ist, und
wobei der zweite Quellen-/Senken-Bereich (124) vom aktiven Substrat (102a) beabstandet und vom aktiven Substrat (102a) durch eine Quellen-/Senken-Isolierstruktur (112), die unter dem zweiten Quellen-/Senken-Bereich (124) und über dem aktiven Substrat (102a) angeordnet ist, isoliert ist.

2. Integrierte Schaltungsvorrichtung (100) nach Anspruch 1, wobei sich eine untere Fläche (124L) des zweiten Quellen-/Senken-Bereichs (124) in einer vertikalen (Z-) Richtung auf einer höheren Ebene befindet als eine obere Fläche (FT) des rippenartigen aktiven Bereichs (F1, F2).

3. Integrierte Schaltungsvorrichtung (100) nach einem vorstehenden Anspruch, wobei:
die Quellen-/Senken-Isolierstruktur (114) sich in der ersten horizontalen (X-) Richtung auf dem rippenartigen aktiven Bereich (F1, F2) erstreckt,
wobei der erste Quellen-/Senken-Bereich (122) durch die Quellen-/Senken-Isolierstruktur (114) verläuft und das aktive Substrat (102a) direkt kontaktiert, und
wobei der zweite Quellen-/Senken-Bereich (124) vom aktiven Substrat (102a) beabstandet ist, mit der Quellen-/Senken-Isolierstruktur (114) dazwischen.

4. Integrierte Schaltungsvorrichtung (100), umfassend:
eine rückseitige Verbindungsstruktur (194), die sich in einer ersten horizontalen (X-) Richtung erstreckt;
ein aktives Substrat (102a), das eine Vielzahl von rippenartigen aktiven Bereichen (F1, F2) beinhaltet, die sich in der ersten horizontalen (X-) Richtung auf der rückseitigen Verbindungsstruktur (194) erstrecken, wobei das aktive Substrat (102a) ein mit Verunreinigungen dotiertes Halbleitersubstrat umfasst;
einen Metallsilizidfilm (192) zwischen der rückseitigen Verbindungsstruktur (194) und dem aktiven Substrat (102a);
eine Vielzahl von Gatter-Strukturen (140), die auf der Vielzahl von rippenartigen aktiven Bereichen (F1, F2) angeordnet sind und sich in einer zweiten horizontalen (Y-) Richtung senkrecht zur ersten horizontalen (X-) Richtung auf dem aktiven Substrat (102a) erstrecken; und
einen ersten Quellen-/Senken-Bereich (122) und einen zweiten Quellen-/Senken-Bereich (124), die in der ersten horizontalen (X-) Richtung voneinander beabstandet sind, mit einer Gatter-Struktur (140) dazwischen auf dem aktiven Substrat (102a);
wobei der erste Quellen-/Senken-Bereich (122) das aktive Substrat (102a) direkt kontaktiert, sodass die rückseitige Verbindungsstruktur (194) durch den Metallsilizidfilm (192) und das aktive Substrat (102a) elektrisch mit dem ersten Quellen-/Senken-Bereich (122) verbunden ist; und
wobei die integrierte Schaltungsvorrichtung (100) weiter eine Vielzahl von Nanoblattstapeln (NSS) umfasst, die auf den rippenartigen aktiven Bereichen (F1, F2) angeordnet und von der Vielzahl von Gatter-Strukturen (140) umgeben sind,
wobei der erste Quellen-/Senken-Bereich (122) in einer ersten Aussparung (RS) angeordnet ist, die im aktiven Substrat (102a) zwischen der Vielzahl von Nanoblattstapeln (NSS) definiert ist, und der zweite Quellen-/Senken-Bereich (124) in einer zweiten Aussparung (RD) angeordnet ist, die im aktiven Substrat (102a) zwischen der Vielzahl von Nanoblattstapeln (NSS) definiert ist, und
wobei der zweite Quellen-/Senken-Bereich (124) durch eine Quellen-/Senken-Isolierstruktur (116), die auf einer unteren Fläche (124L) des zweiten Quellen-/Senken-Bereichs (124) angeordnet ist, vom aktiven Substrat (102a) beabstandet ist, wobei die Quellen-/Senken-Isolierstruktur (116) den zweiten Quellen-/Senken-Bereich (124) in einer vertikalen (Z-) Richtung überlappt und das aktive Substrat (102a) in der vertikalen (Z-) Richtung durchdringt.

5. Integrierte Schaltungsvorrichtung nach Anspruch 4, wobei eine Breite (W1) der Quellen-/Senken-Isolierstruktur (116) in der ersten horizontalen (X-) Richtung und/oder der zweiten horizontalen (Y-) Richtung größer ist als eine Breite (W2) des zweiten Quellen-/Senken-Bereichs (124) in der ersten horizontalen (X-) Richtung und/oder der zweiten horizontalen (Y-) Richtung.

6. Integrierte Schaltungsvorrichtung (100) nach Anspruch 4 oder 5, wobei sich die untere Fläche (124L) des zweiten Quellen-/Senken-Bereichs (124) in einer vertikalen (Z-) Richtung auf einer höheren Ebene befindet als eine obere Fläche (FT) des rippenartigen aktiven Bereichs (F1, F2).

7. Integrierte Schaltungsvorrichtung (100) nach einem vorstehenden Anspruch, wobei:
das aktive Substrat (102a) einen P-Kanal-Metalloxidhalbleiter-, PMOS-, Transistorbereich und einen N-Kanal-Metalloxidhalbleiter-, NMOS-, Transistorbereich umfasst,
wobei der rippenartige aktive Bereich (F1, F2) einen ersten rippenartigen aktiven Bereich (F1) des PMOS-Transistorbereichs und einen zweiten rippenartigen aktiven Bereich (F2) des NMOS-Transistorbereichs umfasst,
wobei der erste rippenartige aktive Bereich (F1) einen dritten rippenartigen aktiven Bereich (F11) und einen vierten rippenartigen aktiven Bereich (F12) umfasst, die in der zweiten horizontalen (Y-) Richtung voneinander beabstandet sind und sich in der ersten horizontalen (X-) Richtung parallel zueinander erstrecken, und der zweite rippenartige aktive Bereich (F2) einen fünften rippenartigen aktiven Bereich (F21) und einen sechsten rippenartigen aktiven Bereich (F22) umfasst, die in der zweiten horizontalen (Y-) Richtung voneinander beabstandet sind und sich in der ersten horizontalen (X-) Richtung parallel zueinander erstrecken, und
wobei der dritte rippenartige aktive Bereich (F11), der vierte rippenartige aktive Bereich (F12), der fünfte rippenartige aktive Bereich (F21) und der sechste rippenartige aktive Bereich (F22) jeweils unabhängige aktive Substrate sind und voneinander beabstandet sind, mit einem Vorrichtungsisolierfilm (106) dazwischen.

8. Integrierte Schaltungsvorrichtung (100) nach einem der Ansprüche 1-6, wobei:
das aktive Substrat (102a) einen PMOS-Transistorbereich (PA) und einen NMOS-Transistorbereich (NA) umfasst,
wobei der rippenartige aktive Bereich (F1, F2) einen ersten rippenartigen aktiven Bereich (F1) des PMOS-Transistorbereichs (PA) und einen zweiten rippenartigen aktiven Bereich (F2) des NMOS-Transistorbereichs (NA) umfasst,
wobei der erste rippenartige aktive Bereich (F1) einen dritten rippenartigen aktiven Bereich (F11) und einen vierten rippenartigen aktiven Bereich (F12) umfasst, die in der zweiten horizontalen (Y-) Richtung voneinander beabstandet sind und sich in der ersten horizontalen (X-) Richtung parallel zueinander erstrecken,
wobei der zweite rippenartige aktive Bereich (F2) einen fünften rippenartigen aktiven Bereich (F21) und einen sechsten rippenartigen aktiven Bereich (F22) umfasst, die in der zweiten horizontalen (Y-) Richtung voneinander beabstandet sind und sich in der ersten horizontalen (X-) Richtung parallel zueinander erstrecken,
wobei der erste rippenartige aktive Bereich (F1) eine integrale Struktur aufweist, in der der dritte rippenartige aktive Bereich (F11) und der vierte rippenartige aktive Bereich (F12) verbunden sind,
wobei der zweite rippenartige aktive Bereich (F2) eine integrale Struktur aufweist, in der der fünfte rippenartige aktive Bereich (F21) und der sechste rippenartige aktive Bereich (F22) verbunden sind, und
wobei der erste rippenartige aktive Bereich (F1) und der zweite rippenartige aktive Bereich (F2) voneinander beabstandet sind, mit einem Vorrichtungsisolierfilm (106) dazwischen.

9. Integrierte Schaltungsvorrichtung (100) nach Anspruch 8, wobei der Metallsilizidfilm (192) eine untere Fläche des ersten rippenartigen aktiven Bereichs (F1) und eine untere Fläche des zweiten rippenartigen aktiven Bereichs (F2) auf der rückseitigen Verbindungsstruktur (194) vollständig bedeckt.

10. Integrierte Schaltungsvorrichtung (100) nach einem vorstehenden Anspruch, wobei sich der Metallsilizidfilm in der ersten horizontalen (X-) Richtung auf der rückseitigen Verbindungsstruktur (194) erstreckt und den zweiten Quellen-/Senken-Bereich in einer vertikalen (Z-) Richtung überlappt.

11. Integrierte Schaltungsvorrichtung (100) nach einem vorstehenden Anspruch, die weiter eine obere Kontaktstruktur (154) in direktem Kontakt mit dem zweiten Quellen-/Senken-Bereich (124) auf dem zweiten Quellen-/Senken-Bereich (124) umfasst.

12. Integrierte Schaltungsvorrichtung (100) nach einem der Ansprüche 1 bis 6, umfassend:
eine untere Isolierstruktur (181) auf der rückseitigen Verbindungsstruktur (194); und
eine untere Kontaktstruktur (184), die die untere Isolierstruktur (181) durchdringt und das aktive Substrat (102a) elektrisch mit der rückseitigen Verbindungsstruktur (194) verbindet;
wobei der Metallsilizidfilm (182) zwischen dem aktiven Substrat (102a) und der unteren Kontaktstruktur (184) angeordnet ist.

13. Integrierte Schaltungsvorrichtung (100) nach Anspruch 12, wobei die untere Kontaktstruktur (184) den ersten Quellen-/Senken-Bereich (122) in einer vertikalen (Z-) Richtung überlappt.

14. Integrierte Schaltungsvorrichtung (100) nach Anspruch 12 oder Anspruch 13, die weiter eine obere Kontaktstruktur (154) umfasst, die auf dem zweiten Quellen-/Senken-Bereich (124) angeordnet ist und den zweiten Quellen-/Senken-Bereich (124) direkt kontaktiert.

## Revendications

1. Dispositif de circuit intégré (100) comprenant :
une structure d'interconnexion arrière (194) s'étendant dans une première direction horizontale (X) ;
un substrat actif (102a) incluant une pluralité de zones actives de type ailette (F1, F2) s'étendant dans la première direction horizontale (X) sur la structure d'interconnexion arrière (194), le substrat actif (102a) comprenant un substrat semi-conducteur dopé avec des impuretés ;
un film de siliciure métallique (192) entre la structure d'interconnexion arrière (194) et le substrat actif (102a) ;
une pluralité de structures de grille (140) disposées sur la pluralité de zones actives de type ailette (F1, F2) et s'étendant dans une seconde direction horizontale (Y) perpendiculaire à la première direction horizontale (X) sur le substrat actif (102a) ; et
une première zone source/drain (122) et une seconde zone source/drain (124) espacées l'une de l'autre dans la première direction horizontale (X) avec une structure de grille (140) entre elles sur le substrat actif (102a) ; et
dans lequel la première zone source/drain (122) est en contact direct avec le substrat actif (102a) de telle sorte que la structure d'interconnexion arrière (194) est raccordée électriquement à la première zone source/drain (122) à travers le film de siliciure métallique (192) et le substrat actif (102a) ;
le dispositif de circuit intégré (100) comprenant en outre une pluralité d'empilements de nanofeuilles (NSS) disposés sur les zones actives de type ailette (F1, F2) et entourés par la pluralité de structures de grille (140),
dans lequel la première zone source/drain (122) est disposée dans un premier évidement (RS) défini dans le substrat actif (102a) entre la pluralité d'empilements de nanofeuilles (NSS), et la seconde zone source/drain (124) est disposée dans un second évidement (RD) défini dans le substrat actif (102a) entre la pluralité d'empilements de nanofeuilles (NSS), et
dans lequel le seconde zone source/drain (124) est espacée du substrat actif (102a) et isolée du substrat actif (102a) par une structure isolante source/drain (112) qui est disposée sous la seconde zone source/drain (124) et au-dessus du substrat actif (102a).

2. Dispositif de circuit intégré (100) selon la revendication 1, dans lequel une surface inférieure (124L) de la seconde zone source/drain (124) est située à un niveau plus élevé qu'une surface supérieure (FT) de la zone active de type ailette (F1, F2) dans une direction verticale (Z).

3. Dispositif de circuit intégré (100) selon une quelconque revendication précédente, dans lequel :
la structure isolante source/drain (114) s'étend dans la première direction horizontale (X) sur la zone active de type ailette (F1, F2),
dans lequel la première zone source/drain (122) passe par la structure isolante source/drain (114) et entre directement en contact avec le substrat actif (102a), et
dans lequel la seconde zone source/drain (124) est espacée du substrat actif (102a) avec la structure isolante source/drain (114) entre elles.

4. Dispositif de circuit intégré (100) comprenant :
une structure d'interconnexion arrière (194) s'étendant dans une première direction horizontale (X) ;
un substrat actif (102a) incluant une pluralité de zones actives de type ailette (F1, F2) s'étendant dans la première direction horizontale (X) sur la structure d'interconnexion arrière (194), le substrat actif (102a) comprenant un substrat semi-conducteur dopé avec des impuretés ;
un film de siliciure métallique (192) entre la structure d'interconnexion arrière (194) et le substrat actif (102a) ;
une pluralité de structures de grille (140) disposées sur la pluralité de zones actives de type ailette (F1, F2) et s'étendant dans une seconde direction horizontale (Y) perpendiculaire à la première direction horizontale (X) sur le substrat actif (102a) ; et
une première zone source/drain (122) et une seconde zone source/drain (124) espacées l'une de l'autre dans la première direction horizontale (X) avec une structure de grille (140) entre elles sur le substrat actif (102a) ;
dans lequel la première zone source/drain (122) est en contact direct avec le substrat actif (102a) de telle sorte que la structure d'interconnexion arrière (194) est raccordée électriquement à la première zone source/drain (122) à travers le film de siliciure métallique (192) et le substrat actif (102a) ; et
le dispositif de circuit intégré (100) comprenant en outre une pluralité d'empilements de nanofeuilles (NSS) disposés sur les zones actives de type ailette (F1, F2) et entourés par la pluralité de structures de grille (140),
dans lequel la première zone source/drain (122) est disposée dans un premier évidement (RS) défini dans le substrat actif (102a) entre la pluralité d'empilements de nanofeuilles (NSS), et la seconde zone source/drain (124) est disposée dans un second évidement (RD) défini dans le substrat actif (102a) entre la pluralité d'empilements de nanofeuilles (NSS), et
dans lequel la seconde zone source/drain (124) est espacée du substrat actif (102a) par une structure isolante source/drain (116) disposée sur une surface inférieure (124L) de la seconde zone source/drain (124), dans lequel ladite structure isolante source/drain (116) chevauche la seconde zone source/drain (124) dans une direction verticale (Z) et pénètre dans le substrat actif (102a) dans la direction verticale (Z).

5. Dispositif de circuit intégré selon la revendication 4, dans lequel la largeur (W1) de la structure isolante source/drain (116) dans la première direction horizontale (X) et/ou la seconde direction horizontale (Y) est supérieure à la largeur (W2) de la seconde zone source/drain (124) dans la première direction horizontale (X) et/ou la seconde direction horizontale (Y).

6. Dispositif de circuit intégré (100) selon la revendication 4 ou 5, dans lequel la surface inférieure (124L) de la seconde zone source/drain (124) est située à un niveau plus élevé qu'une surface supérieure (FT) de la zone active de type ailette (F1, F2) dans une direction verticale (Z).

7. Dispositif de circuit intégré (100) selon une quelconque revendication précédente, dans lequel :
le substrat actif (102a) comprend une zone de transistor à semi-conducteur à oxyde métallique à canal P, PMOS, et une zone de transistor à semi-conducteur à oxyde métallique à canal N, NMOS,
dans lequel la zone active de type ailette (F1, F2) comprend une première zone active de type ailette (F1) de la zone de transistor PMOS et une deuxième zone active de type ailette (F2) de la zone de transistor NMOS,
dans lequel la première zone active de type ailette (F1) comprend une troisième zone active de type ailette (F11) et une quatrième zone active de type ailette (F12) espacées l'une de l'autre dans la seconde direction horizontale (Y) et s'étendant parallèlement l'une à l'autre dans la première direction horizontale (X), et la deuxième zone active de type ailette (F2) comprend une cinquième zone active de type ailette (F21) et une sixième zone active de type ailette (F22) espacées l'une de l'autre dans la seconde direction horizontale (Y) et s'étendant parallèlement l'une à l'autre dans la première direction horizontale (X), et
dans lequel la troisième zone active de type ailette (F11), la quatrième zone active de type ailette (F12), la cinquième zone active de type ailette (F21) et la sixième zone active de type ailette (F22) sont respectivement des substrats actifs indépendants et sont espacées les unes des autres avec un film d'isolation de dispositif (106) entre eux.

8. Dispositif de circuit intégré (100) selon l'une quelconque des revendications 1-6, dans lequel :
le substrat actif (102a) comprend une zone de transistor PMOS (PA) et une zone de transistor NMOS (NA),
dans lequel la zone active de type ailette (F1, F2) comprend une première zone active de type ailette (F1) de la zone de transistor PMOS (PA) et une deuxième zone active de type ailette (F2) de la zone de transistor NMOS (NA),
dans lequel la première zone active de type ailette (F1) comprend une troisième zone active de type ailette (F11) et une quatrième zone active de type ailette (F12) espacées l'une de l'autre dans la seconde direction horizontale (Y) et s'étendant parallèlement l'une à l'autre dans la première direction horizontale (X),
dans lequel la deuxième zone active de type ailette (F2) comprend une cinquième zone active de type ailette (F21) et une sixième zone active de type ailette (F22) espacées dans la seconde direction horizontale (Y) et s'étendant parallèlement l'une à l'autre dans la première direction horizontale (X),
dans lequel la première zone active de type ailette (F1) présente une structure intégrale dans laquelle la troisième zone active de type ailette (F11) et la quatrième zone active de type ailette (F12) sont raccordées,
dans lequel la deuxième zone active de type ailette (F2) présente une structure intégrale dans laquelle la cinquième zone active de type ailette (F21) et la sixième zone active de type ailette (F22) sont raccordées, et
dans lequel la première zone active de type ailette (F1) et la deuxième zone active de type ailette (F2) sont espacées l'une de l'autre avec un film d'isolation de dispositif (106) entre elles.

9. Dispositif de circuit intégré (100) selon la revendication 8, dans lequel le film de siliciure métallique (192) recouvre entièrement une surface inférieure de la première zone active de type ailette (F1) et une surface inférieure de la deuxième zone active de type ailette (F2) sur la structure d'interconnexion arrière (194).

10. Dispositif de circuit intégré (100) selon une quelconque revendication précédente, dans lequel le film de siliciure métallique s'étend dans la première direction horizontale (X) sur la structure d'interconnexion arrière (194) et chevauche la seconde zone source/drain dans une direction verticale (Z).

11. Dispositif de circuit intégré (100) selon une quelconque revendication précédente, comprenant en outre une structure de contact supérieure (154) en contact direct avec la seconde zone source/drain (124) sur la seconde zone source/drain (124).

12. Dispositif de circuit intégré (100) selon l'une quelconque des revendications 1 à 6, comprenant :
une structure isolante inférieure (181) sur la structure d'interconnexion arrière (194) ; et
une structure de contact inférieure (184) pénétrant dans la structure isolante inférieure (181) et raccordant électriquement le substrat actif (102a) à la structure d'interconnexion arrière (194) ;
dans lequel le film de siliciure métallique (182) est disposé entre le substrat actif (102a) et la structure de contact inférieure (184).

13. Dispositif de circuit intégré (100) selon la revendication 12, dans lequel la structure de contact inférieure (184) chevauche la première zone source/drain (122) dans une direction verticale (Z).

14. Dispositif de circuit intégré (100) selon la revendication 12 ou la revendication 13, comprenant en outre une structure de contact supérieure (154) disposée sur la seconde zone source/drain (124), et en contact direct avec la seconde zone source/drain (124).
